# EUROPEAN PATENT APPLICATION

(11) **EP 4 669 053 A2**
(43) Date of publication of application: **24.12.2025**
(21) Application number: 25182460.3
(22) Date of filing: 12.06.2025
(51) Int. Cl.: H10D 30/01, H10B 51/30, H10D 30/67, H10D 30/69, H10D 62/10, H10D 64/68

(54) **TRANSISTOR ARRANGEMENTS WITH PROGRAMMABLE GATES FOR THRESHOLD VOLTAGE TUNING**

(30) Priority: 17.06.2024 US 202418744869
(71) Applicant: Intel Corporation, Santa Clara, CA 95054 (US)
(72) Inventor: SHARMA, Abhishek A., Portland, 97229 (US); GHANI, Tahir, Portland, 97229 (US); MURTHY, Anand S., Portland, 97229 (US); GOMES, Wilfred, Portland, 97229 (US)
(74) Representative: 2SPL Patentanwälte PartG mbB

(57) **Abstract**

Disclosed herein are transistor arrangements with programmable gates for threshold voltage tuning, and related IC structures, devices, and techniques. As an example, a transistor includes a channel material (102); a first gate electrode material (108); a first gate insulator (106), wherein the first gate insulator is between the channel material and the first gate electrode material; a second gate insulator (110), wherein the first gate electrode material is between the first gate insulator and the second gate insulator; and a second gate electrode material (112), wherein the second gate insulator is between the first gate electrode material and the second gate electrode material. Together, the first gate insulator and the first gate electrode material may form the main gate for turning the transistor on and off, while the second gate insulator and the second gate electrode material may form a programmable gate for threshold voltage tuning of the transistor.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional side view of a transistor gate-channel arrangement including a programmable gate for threshold voltage tuning, in accordance with various embodiments.
FIGS. 2-6 are cross-sectional side views of example single-gate transistors including a programmable gate for threshold voltage tuning, in accordance with various embodiments.
FIGS. 7-9 are cross-sectional side views of example double-gate transistors including a programmable gate for threshold voltage tuning, in accordance with various embodiments.
FIGS. 10A and 10B are perspective and cross-sectional side views, respectively, of an example tri-gate transistor including a programmable gate for threshold voltage tuning, in accordance with various embodiments.
FIGS. 11A and 11B are perspective and cross-sectional side views, respectively, of an example all-around gate transistor including a programmable gate for threshold voltage tuning, in accordance with various embodiments.
FIGS. 12A-12F illustrate cross-sectional side views and top-down views of example transistor arrangements with programmable gates for threshold voltage tuning, according to some embodiments of the present disclosure.
FIGS. 13A-13B provide schematic illustrations of microelectronic arrangements in which transistor arrangements with programmable gates for threshold voltage tuning may be implemented, according to some embodiments of the present disclosure.
FIG. 14 illustrates top views of a wafer and dies that may include one or more integrated circuit (IC) structures with transistor arrangements with programmable gates for threshold voltage tuning, in accordance with various embodiments.
FIG. 15 is a side, cross-sectional view of an IC device that may include one or more IC structures with transistor arrangements with programmable gates for threshold voltage tuning, in accordance with various embodiments.
FIG. 16 is a side, cross-sectional view of an IC package that may include one or more IC structures with transistor arrangements with programmable gates for threshold voltage tuning, in accordance with various embodiments.
FIG. 17 illustrates a cross-sectional side view of an IC device assembly that may include one or more IC structures with transistor arrangements with programmable gates for threshold voltage tuning, in accordance with various embodiments.
FIG. 18 is a block diagram of an example computing device that may include one or more IC structures with transistor arrangements with programmable gates for threshold voltage tuning, in accordance with various embodiments.
FIG. 19 is a block diagram of an example processing device that may include one or more IC structures with transistor arrangements with programmable gates for threshold voltage tuning, in accordance with various embodiments.

### Detailed Description

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating transistor arrangements with programmable gates for threshold voltage tuning as described herein, it might be useful to first understand phenomena that may come into play in certain transistor arrangements. The following foundational information may be viewed as a basis from which the present disclosure may be properly explained. Such information is offered for purposes of explanation only and, accordingly, should not be construed in any way to limit the broad scope of the present disclosure and its potential applications.

The threshold voltage (typically denoted as "Vth") of a transistor is the minimum gate-to-source voltage (typically denoted as "Vgs") required to create a conductive path between the source and drain terminals. It is an important parameter in determining when a transistor turns on (conducts current) or turns off (blocks current). As one example to indicate the importance of threshold voltage, for digital circuits, transistors act as switches, where the threshold voltage determines the point at which the transistor switches from off (non-conductive) to on (conductive) state. In another example, the threshold voltage influences the power consumption of a transistor. A higher threshold voltage generally leads to lower leakage currents when the transistor is off, reducing static power consumption. Conversely, a lower threshold voltage can reduce the voltage required to turn the transistor on, reducing dynamic power consumption during switching. Threshold voltage is also important for performance and speed, where typically, lower threshold voltage transistors can switch faster because they require a smaller voltage swing to transition from off to on, improving the speed of the circuit, but this can come at the cost of higher leakage currents.

Characteristics such as performance, power consumption, and reliability of transistor arrangements may be balanced by tuning the threshold voltage of different transistors. Furthermore, the threshold voltage can vary with temperature and manufacturing process variations. Therefore, tuning the threshold voltage may help ensure that the transistors operate correctly across different temperatures and manufacturing lots.

Traditionally, the threshold voltage of various transistors is adjusted during the manufacturing of IC structures. This adjustment may be achieved by selecting specific semiconductor materials for the transistor channels, changing doping levels of semiconductor materials, choosing particular conductive materials for the gate electrodes, and tweaking other design parameters. At this stage, it is feasible to ensure that different transistors have the necessary threshold voltages. However, once an IC structure is fabricated, modifying the threshold voltage of individual transistors becomes complex and is often impractical.

Disclosed herein are transistor arrangements with programmable gates for threshold voltage tuning, and related IC structures, devices, and techniques. Embodiments of the present disclosure are based on recognition that conventional means for threshold voltage tuning of transistors may be improved by providing programmable gates coupled to the transistors for which it may be desirable to tune the threshold voltage after the manufacturing of an IC structure. In one aspect, an example transistor with a programmable gate may include a channel material and a gate stack comprising a stack of a first gate insulator, a first gate electrode material, a second gate insulator, and a second gate electrode material, listed in the order from the closest to the channel material to farthest away from the channel material. The second gate insulator may be a programmable insulator, where, as used herein, a material/arrangement is described as "programmable" if one or more properties of the material/arrangement can be dynamically altered (i.e., "programmed") in response to external stimuli such as electrical, optical, thermal, or magnetic signals. Examples of programmable insulator materials include ferroelectric (FE) materials and antiferroelectric (AFE) materials. Examples of programmable insulator arrangements include a charge-trapping arrangement. By applying a signal to the second gate electrode material (e.g., by applying an electrical signal such as voltage), properties of the programmable second gate insulator may be changed and remain changed even when the signal is no longer applied to the second gate electrode material, which may, in turn, affect the threshold voltage of the transistor. Together, the first gate insulator and the first gate electrode material may form the main gate for turning the transistor on and off, while the second gate insulator and the second gate electrode material may form a programmable gate for threshold voltage tuning of the transistor. Providing transistor arrangements with programmable gates enable tuning threshold voltage after an IC structure is fabricated. This, in turn, may be advantageous across multiple dimensions, including power efficiency, performance, reliability, and adaptability. For example, dynamic threshold voltage tuning may be used to enable dynamic control of power consumption and speed, where lowering the threshold voltage can increase the speed of the transistor, while raising it can reduce power leakage, particularly in standby modes. In other examples, dynamic threshold voltage tuning may be used to compensate for aging of transistors and/or manufacturing process variations among the transistors, improve yield by making it possible to correct for devices that would otherwise be out of spec, or manage a thermal profile of the IC structure.

In the following detailed description, various aspects of the illustrative implementations may be described using terms commonly employed by those skilled in the art to convey the substance of their work to others skilled in the art. For example, the term "connected" means a direct electrical connection between the things that are connected (e.g., with the things being in electrically conductive and/or physical contact, e.g., in direct contact), without any intermediary devices, while the term "coupled" means either a direct electrical connection between the things that are connected, or an indirect connection through one or more passive or active intermediary devices. Describing A and B are being "in contact" includes A and B being in direct physical contact, possibly with an interface that may form when A and B are brough into direct physical contact with one another. The term "circuit" means one or more passive and/or active components that are arranged to cooperate with one another to provide a desired function. The terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/-20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 20%, e.g., within +/- 5% or within +/- 2% of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

Although certain elements may be referred to in the singular herein, such elements may include multiple sub-elements. For example, "an insulator material" may include one or more insulator materials. The term "insulating" and variations thereof (e.g., "insulative" or "insulator") means "electrically insulating," the term "conducting" and variations thereof (e.g., "conductive" or "conductor") means "electrically conducting," unless otherwise specified. For example, the term "insulator material" may refer to solid materials (and/or liquid materials that solidify after processing as described herein) that are substantially electrically non-conducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. With reference to optical signals and/or devices, components and elements that operate on or using optical signals, the term "conducting/conductive" can also mean "optically conducting/conductive."

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

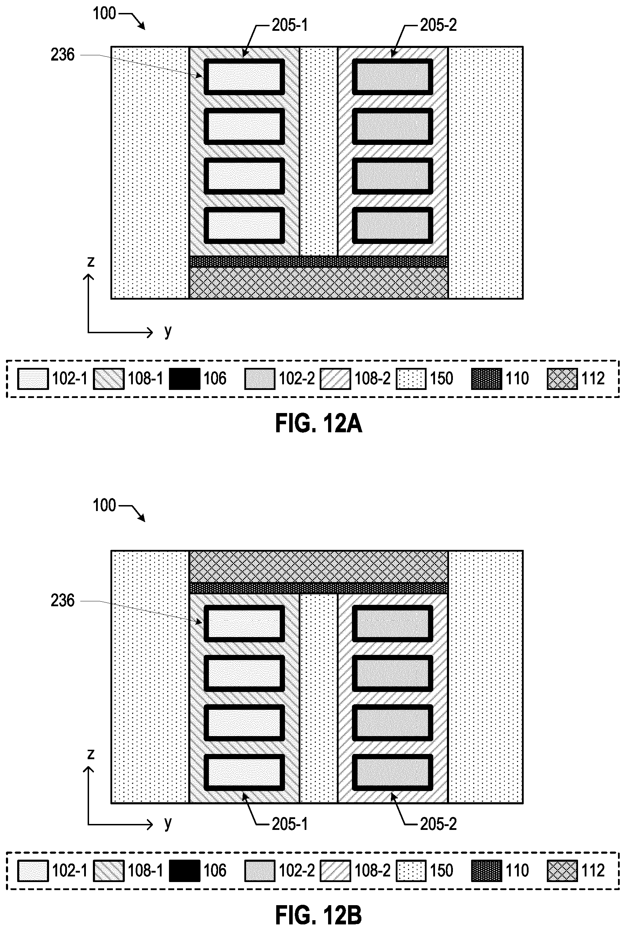

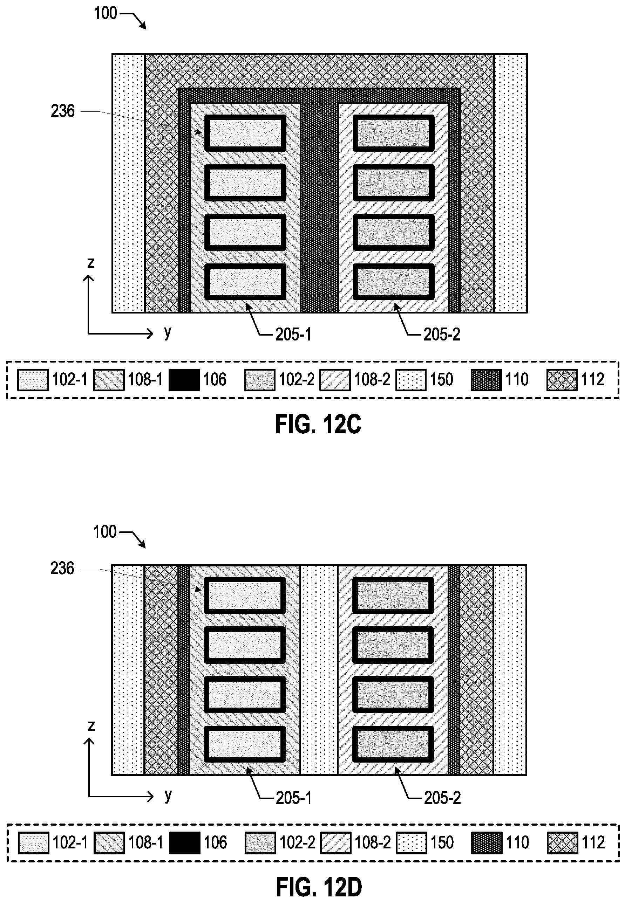

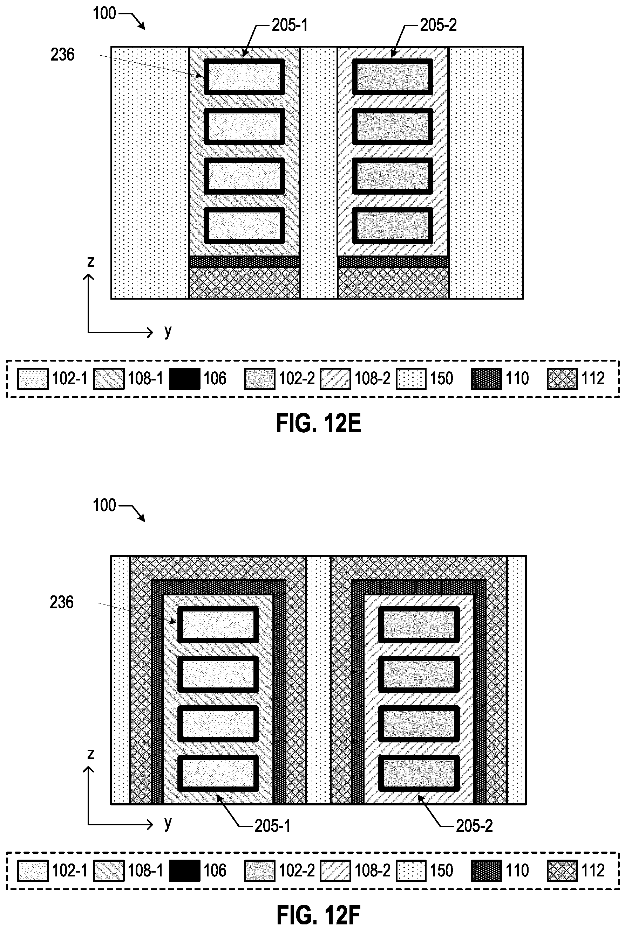

Any of the features discussed with reference to any of accompanying drawings herein may be combined with any other features to form IC structures with programmable gates for threshold voltage tuning, as appropriate. A number of elements of the drawings are shared with others of the drawings; for ease of discussion, a description of these elements is not repeated, and these elements may take the form of any of the embodiments disclosed herein. For convenience, a collection of drawings labeled with letters may be referred to without letters (e.g., a collection of drawings shown in FIGS. 12A-12F may be referred to as FIG. 12).

The drawings are not necessarily to scale. In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures with programmable gates for threshold voltage tuning as described herein.

Various IC structures with programmable gates for threshold voltage tuning as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

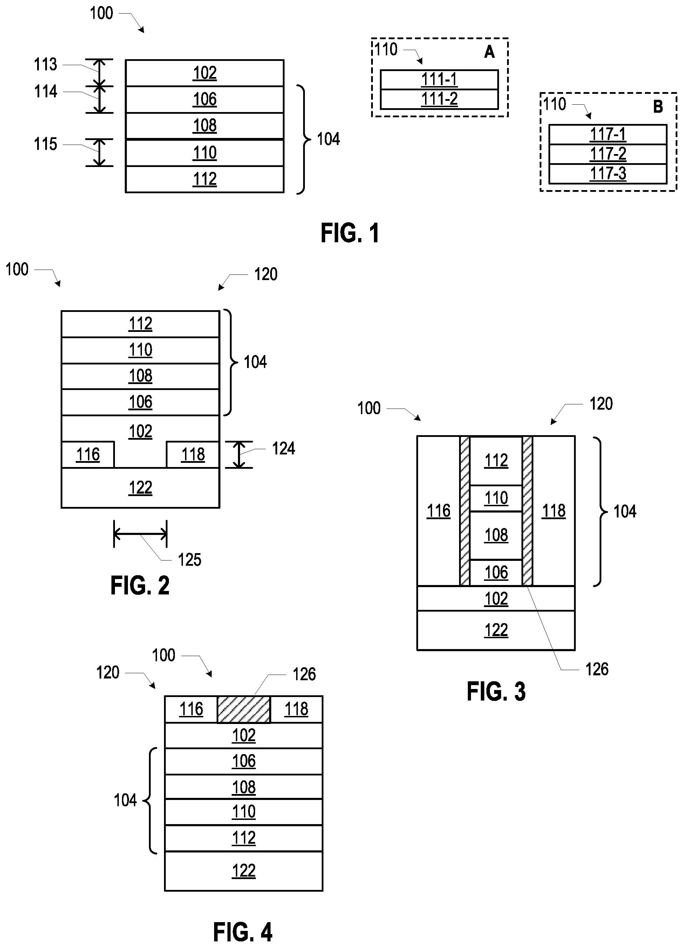

FIG. 1 is a cross-sectional side view of an IC structure 100 including a channel material 102, and further including a transistor gate stack 104 (also referred to as a "transistor gate stack 104" herein), in accordance with various embodiments. The transistor gate stack 104 may include a gate electrode material 108, a gate insulator material 106 disposed between the channel material 102 and the gate electrode material 108, an additional gate insulator material 110, and an additional gate electrode material 112, where the gate electrode material 108 is disposed between the gate insulator material 106 and the additional gate insulator material 110, and the additional gate insulator material 110 is disposed between the gate electrode material 108 and the additional gate electrode material 112.

In various embodiments, the channel material 102 may be composed of semiconductor material systems including, for example, N-type or P-type materials systems. In some embodiments, the channel material 102 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel material 102 may include a combination of semiconductor materials. In some embodiments, the channel material 102 may include a monocrystalline semiconductor, such as silicon (Si) or germanium (Ge). In some embodiments, the channel material 102 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where a transistor with the channel material 102 is an N-type metal-oxide-semiconductor (NMOS) transistor), the channel material 102 may include a III-V material having a relatively high electron mobility, such as, but not limited to InGaAs, InP, InSb, and InAs. For some such embodiments, the channel material 102 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where a transistor with the channel material 102 is a P-type metal-oxide-semiconductor (PMOS) transistor), the channel material 102 may advantageously be a group IV material having a high hole mobility, such as, but not limited to Ge or a Ge-rich SiGe alloy. For some example embodiments, the channel material 102 may have a Ge content between 0.6 and 0.9, and advantageously may be at least 0.7.

In some embodiments, the channel material 102 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor is a thin-film transistor (TFT), the channel material 102 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material 102 may have a thickness between about 5 and 75 nanometers, including all values and ranges therein. In some embodiments, a thin-film channel material may be deposited at relatively low temperatures, which allows depositing the channel material within the thermal budgets imposed on back end fabrication to avoid damaging other components, e.g., front end components such as the logic devices.

In some embodiments, the gate insulator material 106 may include a high-k dielectric. The high-k dielectric may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate insulator material 106 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate insulator material 106 during fabrication of a transistor (e.g., any of the transistors 120 discussed herein) to improve the quality of the gate insulator material 106. The gate insulator material 106 may have a thickness that may, in some embodiments, be between about 0.5 nanometers and 3 nanometers, including all values and ranges therein (e.g., between about 1 and 3 nanometers, or between about 1 and 2 nanometers).

The gate electrode material 108 may include at least one P-type work function metal or N-type work function metal, depending on whether the transistor gate stack 104 is to be included in a PMOS transistor or an NMOS transistor (e.g., any of the transistors 120 discussed below). For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may consist of a stack of two or more metal layers, where one or more metal layers are work function metal layers and at least one metal layer is a fill metal layer. Further metal layers may be included for other purposes, such as to act as a barrier layer.

In some embodiments, the additional gate insulator material 110 may include a programmable insulator material, e.g., may include a hysteretic material or a hysteretic arrangement, which, together, may be referred to as a "hysteretic element," where the term "hysteretic" refers to the fact that the element may function based on the phenomenon of hysteresis. A material or an arrangement may be described as hysteretic if it exhibits the dependence of its state on the history of the material (e.g., on a previous state of the material). FE and AFE materials are one example of hysteretic materials. Layers of different materials arranged in a stack to exhibit charge-trapping phenomena is one example of a hysteretic arrangement.

A FE or an AFE material is a material that exhibits, over some range of temperatures, spontaneous electric polarization, i.e., displacement of positive and negative charges from their original position, where the polarization can be reversed or reoriented by application of an electric field. In particular, an AFE material is a material that can assume a state in which electric dipoles from the ions and electrons in the material may form a substantially ordered (e.g., substantially crystalline) array, with adjacent dipoles being oriented in opposite (antiparallel) directions (i.e., the dipoles of each orientation may form interpenetrating sub-lattices, loosely analogous to a checkerboard pattern), while a FE material is a material that can assume a state in which all of the dipoles point in the same direction. Because the displacement of the charges in FE and AFE materials can be maintained for some time even in the absence of an electric field, such materials may be used to implement a gate insulator of a programmable gate formed by the additional gate insulator material 110 and the additional gate electrode material 112. Because the current state of the electric dipoles in FE and AFE materials depends on the previous state, such materials are hysteretic materials.

A stack of alternating layers of materials that is configured to exhibit charge-trapping is an example of a hysteretic arrangement. Such a stack may include as little as two layers of materials, one of which is a charge-trapping layer (i.e., a layer of a material configured to trap charges when a volage is applied across the material) and the other one of which is a tunnelling layer (i.e., a layer of a material through which the charge is to be tunneled to the charge-trapping layer). The tunnelling layer may include an insulator material such as a material that includes silicon and oxygen (e.g., silicon oxide), or any other suitable insulator. The charge-trapping layer may include a metal or a semiconductor material that is configured to trap charges. For example, a material that includes silicon and nitrogen (e.g., silicon nitride) may be used in/as a charge-trapping layer. Because the trapped charges may be kept in a charge-trapping arrangement for some time even in the absence of an electric field, such arrangements may be used to implement a gate insulator of a programmable gate formed by the additional gate insulator material 110 and the additional gate electrode material 112. Because the presence and/or the amount of trapped charges in a charge-trapping arrangement depends on the previous state, such arrangements are hysteretic arrangements.

In some embodiments, the hysteretic element of the additional gate insulator material 110 may be provided as a layer of a FE or an AFE material. Such an FE/AFE material may include one or more materials that can exhibit sufficient FE/AFE behavior even at thin dimensions, e.g., such as an insulator material at least about 5%, e.g., at least about 7% or at least about 10%, of which is in an orthorhombic phase and/or a tetragonal phase (e.g., as a material in which at most about 95-90% of the material may be amorphous or in a monoclinic phase). For example, such materials may be based on hafnium and oxygen (e.g., hafnium oxides), with various dopants added to ensure sufficient amount of an orthorhombic phase or a tetragonal phase. Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germaniumdoped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used as the hysteretic element and are within the scope of the present disclosure.

In other embodiments, the hysteretic element of the additional gate insulator material 110 may be provided as a stack of alternating layers of materials that can trap charges. In some such embodiments, the stack may be a two-layer stack as shown in FIG. 1 within the dashed contour of an inset A, illustrating that the additional gate insulator material 110 may include a first layer 111-1 and a second layer 111-2, where one of the first layer 111-1 and the second layer 111-2 is a charge-trapping layer, and the other one of the first layer 111-1 and the second layer 111-2 is a tunnelling layer. The tunnelling layer may include an insulator material such as a material that includes silicon and oxygen (e.g., silicon oxide), or any other suitable insulator. The charge-trapping layer may include an electrically conductive material such as a metal, or a semiconductor material. In some embodiments, the charge-trapping layer may include a material that includes silicon and nitrogen (e.g., silicon nitride). In general, any material that has defects that can trap charge may be used in/as a charge-trapping layer. Such defects are very detrimental to operation of logic devices and, therefore, typically, deliberate steps need to be taken to avoid presence of the defects. However, for the additional gate insulator material 110 being a programmable material, such defects are desirable because charge-trapping may be used to represent different states of the additional gate insulator material 110.

In some embodiments of the hysteretic element of the additional gate insulator material 110 being provided as a stack of alternating layers of materials that can trap charges, the stack may be a three-layer stack where an insulator material is provided on both sides of a charge-trapping layer. The three-layer stack is shown in FIG. 1 within the dashed contour of an inset B, illustrating that the additional gate insulator material 110 may include a first layer 117-1, a second layer 117-2, and a third layer 117-3, where the second layer 117-2 may be a charge-trapping layer, while the first layer 117-1 and the third layer 117-3 may be insulator material layers. In such embodiments, a layer of an insulator material on one side of the second layer 117-2 that is the charge-trapping layer (e.g., the insulator material of the first layer 117-1) may be referred to as a "tunnelling layer" while a layer of an insulator material on the other side of the charge-trapping layer (e.g., the insulator material of the third layer 117-3) may be referred to as a "field layer."

In various embodiments of the hysteretic element of the additional gate insulator material 110 being provided as a stack of alternating layers of materials that can trap charges, a thickness of each layer the stack may be between about 0.5 and 10 nanometers, including all values and ranges therein, e.g., between about 0.5 and 5 nanometers. In some embodiment of a three-layer stack, a thickness of each layer of the insulator material may be about 0.5 nanometers, while a thickness of the charge-trapping layer may be between about 1 and 8 nanometers, e.g., between about 2.5 and 7.5 nanometers, e.g., about 5 nanometers. In some embodiments, a total thickness of the hysteretic element provided as a stack of alternating layers of materials that can trap charges (i.e., a hysteretic arrangement) may be between about 1 and 10 nanometers, e.g., between about 2 and 8 nanometers, e.g., about 6 nanometers.

Any suitable conductive materials may be used to implement the additional gate electrode material 112, such as any suitable metals, metal alloys, or conductive nitrides or carbides of metals. In some embodiments, the additional gate electrode material 112 may include any of the materials described with reference to the gate electrode material 108.

In some embodiments, the transistor gate stack 104 may be surrounded by a gate spacer, not shown in FIG. 1. Such a gate spacer would be configured to provide separation between the transistor gate stack 104 and source/drain contacts of the transistor and could be made of a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass. A gate spacer may include pores or air gaps to further reduce its dielectric constant.

The dimensions of the elements of an IC structure 100 may take any suitable values. For example, the channel material 102 may have a thickness 113. In some embodiments, the thickness 113 may be between about 5 nanometers and 100 nanometers, e.g., between about 5 nanometers and 30 nanometers, or between about 5 nanometers and 10 nanometers. The gate insulator material 106 may have a thickness 114. In some embodiments, the thickness 114 may be between about 0.5 nanometers and 3 nanometers, e.g., between about 1 nanometer and 3 nanometers, or between about 1 nanometer and 2 nanometers. The additional gate insulator material 110 may have a thickness 115. In some embodiments, the thickness 115 may be between about 1 nanometer and 15 nanometers, e.g., between about 1 nanometer and 10 nanometers, or between about 1 nanometer and 5 nanometers. In other embodiments, the thickness 115 may be as described above with reference to hysteretic elements.

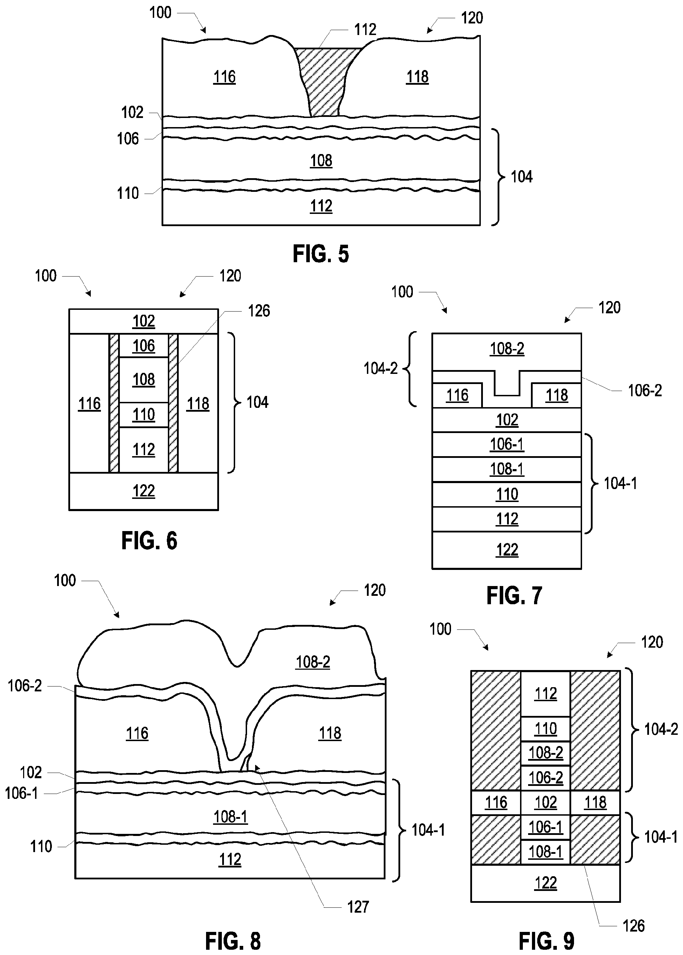

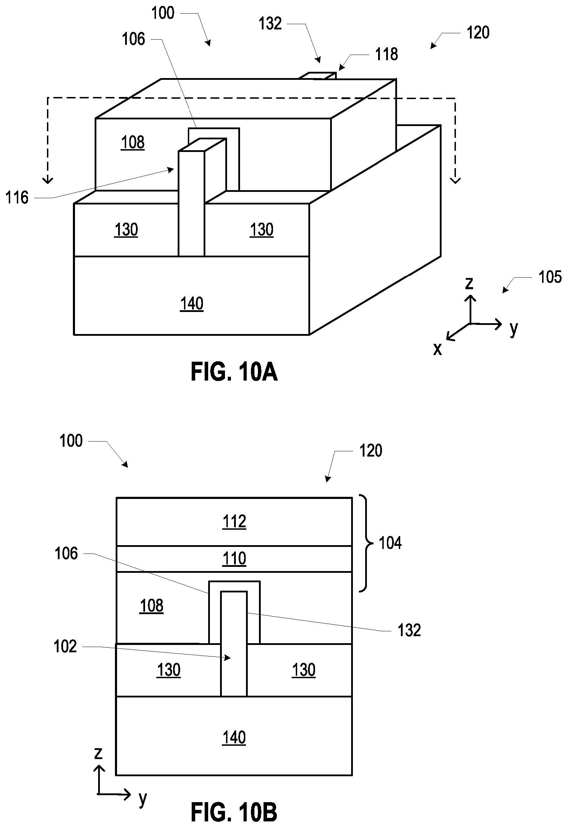

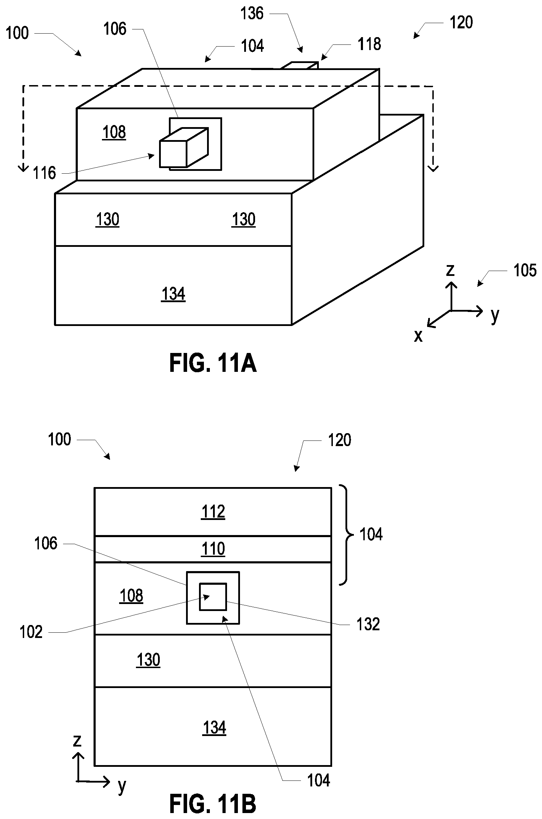

The transistor gate stack 104 may be included in any suitable transistor structure. For example, FIGS. 2-6 are cross-sectional side views of example single-gate transistors 120 including a transistor gate stack 104, FIGS. 7-9 are cross-sectional side views of example double-gate transistors 120 including a transistor gate stack 104, FIGS. 10A and 10B are perspective and cross-sectional side views, respectively, of an example tri-gate transistor 120 including a transistor gate stack 104, and FIGS. 11A and 11B are perspective and cross-sectional side views, respectively, of an example all-around gate transistor 120 including a transistor gate stack 104, in accordance with various embodiments. The transistors 120 illustrated in FIGS. 2-11 do not represent an exhaustive set of transistor structures in which a transistor gate stack 104 may be included but provide examples of such structures. Note that FIGS. 2-6 are intended to show relative arrangements of the components therein, and the transistors 120 may include other components that are not illustrated (e.g., electrical contacts to the gate electrode materials 108, etc.). Any of the components of the transistors 120 discussed below with reference to FIGS. 2-11 may take the form of any of the embodiments of those components discussed above with reference to FIG. 1. Additionally, although various components of the transistors 120 are illustrated in FIGS. 2-11 as being planar rectangles or formed of rectangular solids, this is simply for ease of illustration, and embodiments of these transistors 120 may be curved, rounded, or otherwise irregularly shaped as dictated by the manufacturing processes used to fabricate the transistors 120. The transistors 120 of FIGS. 2-3 may be referred to as "top gate" transistors, while the transistors 120 of FIGS. 4-6 may be referred to as "bottom gate" transistors. Similarly, the transistors 120 of FIGS. 2 and 6 may be referred to as "bottom contact" transistors, while the transistors 120 of FIGS. 3-5 may be referred to as "top contact" transistors.

FIG. 2 depicts a transistor 120 including a transistor gate stack 104 and having a single "top" gate provided by the gate insulator material 106, the gate electrode material 108, the additional gate insulator material 110, and the additional gate electrode material 112. The gate insulator material 106 may be disposed between the gate electrode material 108 and the channel material 102. The gate electrode material 108 may be disposed between the gate insulator material 106 and the additional gate insulator material 110. The additional gate insulator material 110 may be disposed between the gate electrode material 108 and the additional gate electrode material 112. In the embodiment of FIG. 2, the transistor gate stack 104 is shown as disposed above a support 122. The support 122 may be any structure on which the transistor gate stack 104, or other elements of the transistor 120, is disposed. In some embodiments, the support 122 may include a semiconductor, such as silicon. In some embodiments, the support 122 may include an insulating layer, such as an oxide isolation layer. For example, in the embodiments of FIGS. 2 and 3, the support 122 may include a semiconductor material and an interlayer dielectric (ILD) disposed between the semiconductor material and the source/drain (S/D) contact 116, the channel material 102, and the S/D contact 118, to electrically isolate the semiconductor material of the support 122 from the S/D contact 116, the channel material 102, and the S/D contact 118 (and thereby mitigate the likelihood that a conductive pathway will form between the S/D contact 116 and the S/D contact 118 through the support 122) . Examples of ILDs that may be included in a support 122 in some embodiments may include silicon oxide, silicon nitride, aluminum oxide, and/or silicon oxynitride. Any suitable ones of the embodiments of the support 122 described with reference to FIG. 2 may be used for the supports 122 of others of the transistors 120 disclosed herein.

As noted above, the transistor 120 may include an S/D contact 116 and an S/D contact 118 disposed on the support 122, with the channel material 102 disposed between the S/D contact 116 and the S/D contact 118 so that at least some of the channel material 102 is coplanar with at least some of the S/D contact 116 and the S/D contact 118. The S/D contact 116 and the S/D contact 118 may have a thickness 124. In some embodiments, the thickness 124 may be less than the thickness 113 (as illustrated in FIG. 2, with the S/D contact 116 and the S/D contact 118 each disposed between some of the channel material 102 and the support 122), while in other embodiments, the thickness 124 may be equal to the thickness 113. In some embodiments, the channel material 102, and any one or more of the gate insulator material 106, the gate electrode material 108, the additional gate insulator material 110, and the additional gate electrode material 112 may conform around the S/D contact 116 and/or the S/D contact 118. The S/D contact 116 and the S/D contact 118 may be spaced apart by a distance 125 that is the gate length of the transistor 120. In some embodiments, the gate length may be between 20 nanometers and 30 nanometers (e.g., between 22 nanometers and 28 nanometers, or approximately 25 nanometers).

The S/D contact 116 and the S/D contact 118 may be formed using any suitable processes known in the art. For example, one or more layers of metal and/or metal alloys may be deposited or otherwise provided to form the S/D contact 116 and the S/D contact 118, as known for thin-film transistors based on semiconductor oxide systems. Any suitable ones of the embodiments of the S/D contact 116 and the S/D contact 118 described above may be used for any of the S/D contacts 116 and S/D contacts 118 described herein.

FIG. 3 depicts a transistor 120 including a transistor gate stack 104 and having a single "top" gate provided by the gate insulator material 106, the gate electrode material 108, the additional gate insulator material 110, and the additional gate electrode material 112. The gate insulator material 106 may be disposed between the gate electrode material 108 and the channel material 102. The gate electrode material 108 may be disposed between the gate insulator material 106 and the additional gate insulator material 110. The additional gate insulator material 110 may be disposed between the gate electrode material 108 and the additional gate electrode material 112. In the embodiment of FIG. 3, the transistor gate stack 104 is shown as disposed above a support 122. The transistor 120 may include an S/D contact 116 and an S/D contact 118 disposed on the support 122. As discussed above, in some embodiments, the support 122 of FIG. 3 may include a semiconductor material and ILD disposed between the semiconductor material and the S/D contact 116, the channel material 102, and the S/D contact 118, to electrically isolate the semiconductor material of the support 122 from the S/D contact 116, the channel material 102, and the S/D contact 118. In some embodiments, any one or more of the gate insulator material 106, the gate electrode material 108, the additional gate insulator material 110, and the additional gate electrode material 112 may conform around the S/D contact 116 and/or the S/D contact 118. An insulating material 126 may be disposed between the S/D contacts 116/118 and the transistor gate stack 104; the insulating material 126 may include any suitable insulating material, such as any of the ILDs discussed herein. Insulating material 126 on a channel material 102 may include a passivation material (e.g., hafnium oxide, zirconium oxide, aluminum oxide, silicon oxide, silicon nitride, silicon carbide, silicon oxycarbide, silicon oxynitride, titanium oxide, copper oxide, tin oxide, or copper tin oxide) in contact with the channel material 102. In some embodiments, the channel material 102 may include a semiconductor material with an insulating material dopant and/or an opposite conductivity type dopant proximate to the passivation material, and another material (e.g., a non-doped semiconductor material) distal to the passivation material (e.g., so that the semiconductor material with an insulating material dopant and/or an opposite conductivity type dopant is between the non-doped semiconductor material and the insulating material 126).

FIG. 4 depicts a transistor 120 including a transistor gate stack 104 and having a single "bottom" gate provided by the gate insulator material 106, the gate electrode material 108, the additional gate insulator material 110, and the additional gate electrode material 112. The gate insulator material 106 may be disposed between the gate electrode material 108 and the channel material 102. The gate electrode material 108 may be disposed between the gate insulator material 106 and the additional gate insulator material 110. The additional gate insulator material 110 may be disposed between the gate electrode material 108 and the additional gate electrode material 112. In the embodiment of FIG. 4, the transistor gate stack 104 is shown as disposed on a support 122 in an orientation "upside down" to the one illustrated in FIG. 2; that is, the gate insulator material 106, the gate electrode material 108, the additional gate insulator material 110, and the additional gate electrode material 112 may be disposed between the support 122 and the channel material 102. The transistor 120 may include an S/D contact 116 and an S/D contact 118 disposed on the channel material 102 such that the S/D contact 116 and the S/D contact 118 are not coplanar with the channel material 102. An insulating material 126 may be disposed between the S/D contacts 116 and 118, above the channel material 102.

FIG. 5 depicts a transistor 120 having the structure of the transistor 120 of FIG. 4. In particular, the transistor 120 of FIG. 5 includes a transistor gate stack 104 and has a single "bottom" gate provided by the gate insulator material 106, the gate electrode material 108, the additional gate insulator material 110, and the additional gate electrode material 112. The transistor 120 of FIG. 5 may also include a support 122 (not shown) arranged so that the gate insulator material 106, the gate electrode material 108, the additional gate insulator material 110, and the additional gate electrode material 112 are disposed between the support 122 and the channel material 102. The transistor 120 may include an S/D contact 116 and an S/D contact 118 disposed on the channel material 102 such that the S/D contact 116 and the S/D contact 118 are not coplanar with the channel material 102. Any suitable materials may be used to form the transistor 120 of FIG. 5, as discussed above. For example, the gate electrode material 108 may include titanium nitride, the gate insulator material 106 may include hafnium oxide, and the S/D contact 116 and the S/D contact 118 may include aluminum. The gate length of the transistor 120 of FIG. 5 may be approximately 25 nanometers.

FIG. 6 depicts a transistor 120 including a transistor gate stack 104 and having a single "bottom" gate provided by the gate insulator material 106, the gate electrode material 108, the additional gate insulator material 110, and the additional gate electrode material 112. The gate insulator material 106 may be disposed between the gate electrode material 108 and the channel material 102. The gate electrode material 108 may be disposed between the gate insulator material 106 and the additional gate insulator material 110. The additional gate insulator material 110 may be disposed between the gate electrode material 108 and the additional gate electrode material 112. In the embodiment of FIG. 6, the transistor gate stack 104 is shown as disposed on a support 122 in an orientation "upside down" to the one illustrated in FIG. 2; that is, the gate insulator material 106, the gate electrode material 108, the additional gate insulator material 110, and the additional gate electrode material 112 may be disposed between the support 122 and the channel material 102. The transistor 120 may include an S/D contact 116 and an S/D contact 118 disposed on the channel material 102 such that at least some of the S/D contact 116 and at least some of the S/D contact 118 are coplanar with at least some of the channel material 102. In some embodiments, the S/D contact 116 and the S/D contact 118 may each be disposed between some of the channel material 102 and the support 122, as illustrated in FIG. 6, while in other embodiments, the channel material 102 may not extend "above" the S/D contact 116 or the S/D contact 118. In some embodiments, the channel material 102 may conform around the S/D contact 116 and/or the S/D contact 118.

FIG. 7 depicts a double-gate transistor 120 including two transistor gate stacks 104-1 and 104-2 and having "bottom" and "top" gates. FIG. 7 illustrates that the transistor gate stack 104-1 is provided by the gate insulator material 106-1, the gate electrode material 108-1, the additional gate insulator material 110, and the additional gate electrode material 112, while the transistor gate stack 104-2 is provided only by the gate insulator material 106-2 and the gate electrode material 108-2, but, in other embodiments, the transistor gate stack 104-2 may also include an additional gate insulator material 110 and an additional gate electrode material 112. Each gate insulator material 106 may be disposed between the corresponding gate electrode material 108 and the channel material 102. Each gate electrode material 108 may be disposed between the gate insulator material 106 and the additional gate insulator material 110. Each additional gate insulator material 110 may be disposed between the gate electrode material 108 and the additional gate electrode material 112. The transistor 120 may include an S/D contact 116 and an S/D contact 118 disposed proximate to the channel material 102. In the embodiment illustrated in FIG. 7, the S/D contact 116 and the S/D contact 118 are disposed on the channel material 102, and the gate insulator material 106-2 is disposed conformably around the S/D contact 116, the channel material 102, and the S/D contact 118. The gate electrode material 108-2 is disposed on the gate insulator material 106-2. In the embodiment of FIG. 7, at least some of the S/D contact 116 and at least some of the S/D contact 118 are coplanar with at least some of the gate insulator material 106-2.

FIG. 8 depicts a double-gate transistor 120 having the structure of the transistor 120 of FIG. 7. In particular, the transistor 120 of FIG. 8 includes two transistor gate stacks 104-1 and 104-2 and having "bottom" and "top" gates as described with reference to FIG. 7. The transistor 120 of FIG. 8 may also include a support 122 (not shown) arranged so that the gate insulator material 106-1, the gate electrode material 108-1, the additional gate insulator material 110, and the additional gate electrode material 112 are disposed between the support 122 and the gate insulator material 106. The transistor 120 may include an S/D contact 116 and an S/D contact 118 disposed on the channel material 102 such that the S/D contact 116 and the S/D contact 118 are not coplanar with the channel material 102. In the embodiment depicted in FIG. 8, the S/D contact 116 and the S/D contact 118 may be deposited on the channel material 102. During manufacture, a void 127 may be formed between the gate insulator material 106-2 and the channel material 102; while such voids 127 may reduce the performance of the transistor 120, the transistor 120 may still function adequately as long as adequate coupling between the gate insulator material 106-2 and the channel material 102 is achieved. Any suitable materials may be used to form the transistor 120 of FIG. 8, as discussed above. For example, the gate electrode material 108-1 may be titanium nitride, the gate insulator materials 106-1 and 106-2 may include hafnium oxide, the S/D contact 116 and the S/D contact 118 may include aluminum, and the gate electrode material 108-2 may include palladium. In some embodiments, the gate length of the transistor 120 of FIG. 8 may be approximately 25 nanometers.

FIG. 9 depicts a double-gate transistor 120 including two transistor gate stacks 104-1 and 104-2 and having "bottom" and "top" gates. FIG. 9 illustrates that the transistor gate stack 104-2 is provided by the gate insulator material 106-2, the gate electrode material 108-2, the additional gate insulator material 110, and the additional gate electrode material 112, while the transistor gate stack 104-1 is provided only by the gate insulator material 106-1 and the gate electrode material 108-1, but, in other embodiments, the transistor gate stack 104-1 may also include an additional gate insulator material 110 and an additional gate electrode material 112. Each gate insulator material 106 may be disposed between the corresponding gate electrode material 108 and the channel material 102. Each gate electrode material 108 may be disposed between the gate insulator material 106 and the additional gate insulator material 110. Each additional gate insulator material 110 may be disposed between the gate electrode material 108 and the additional gate electrode material 112. The transistor 120 may include an S/D contact 116 and an S/D contact 118 disposed proximate to the channel material 102. In the embodiment illustrated in FIG. 9, the S/D contact 116 and the S/D contact 118 are coplanar with the channel material 102 and disposed between the gate insulator materials 106-1 and 106-2. The relative arrangement of the S/D contact 116, the S/D contact 118, and the channel material 102 may take the form of any of the embodiments discussed above with reference to FIG. 2.

FIGS. 10A and 10B are perspective and cross-sectional side views, respectively, of an example tri-gate transistor 120 including a fin 132 that may include a channel material 102 and a transistor gate stack 104 over a portion of the fin 132, in accordance with various embodiments. The transistor gate stack 104 is only shown in FIG. 10B, but not shown in FIG. 10A in order to not clutter the drawing. In the tri-gate transistor 120 illustrated in FIGS. 10A and 10B, a fin 132 formed of a semiconductor material may extend from a base 140 of the semiconductor material. The base 140 may be any structure from which the fin 132 may extend; descriptions provided for the support 122 are applicable to the base 140. An oxide material 130 may be disposed on either side of the fin 132. In some embodiments, the oxide material 130 may include a shallow trench isolation (STI) material. The transistor 120 of FIGS. 10A and 10B may include a channel material 102 in the fin 132 and may further include a transistor gate stack 104 including the gate insulator material 106, the gate electrode material 108, the additional gate insulator material 110, and the additional gate electrode material 112. FIG. 10A is a perspective drawing, an example coordinate system 105 (x-y-z coordinate system) is shown there to assist explanations. The coordinate system 105 is also shown in FIG. 11A, and other drawings illustrating axes (e.g., FIG. 10B, FIG. 11B, and FIGS. 12A-12F illustrating y-z planes) refer to the coordinate system 105.

Some or all layers of the transistor gate stack 104 may wrap around the fin 132, with the channel material 102 corresponding to the portion of the fin 132 wrapped by the transistor gate stack 104. For example, as shown in FIG. 10B, the gate insulator material 106 and the gate electrode material 108 may wrap around the fin 132, while the additional gate insulator material 110 and the additional gate electrode material 112 may only be provided on one side of (i.e., not wrap around) the fin 132. However, in other embodiments, the additional gate insulator material 110 and/or the additional gate electrode material 112 may also wrap around the fin 132. The fin 132 may include an S/D contact 116 and an S/D contact 118 on either side of the transistor gate stack 104, as shown. The composition of the channel material 102, the S/D contact 116, and the S/D contact 118 may take the form of any of the embodiments disclosed herein, or known in the art. Although the fin 132 illustrated in FIGS. 10A and 10B is shown as having a rectangular cross-section, the fin 132 may instead have a cross-section that is rounded or sloped at the "top" of the fin 132, and the transistor gate stack 104 may conform to this rounded or sloped fin 132. In use, the tri-gate transistor 120 may form conducting channels on three "sides" of the fin 132, potentially improving performance relative to single-gate transistors (which may form conducting channels on one "side" of the channel material 102) and double-gate transistors (which may form conducting channels on two "sides" of the channel material 102).

FIGS. 11A and 11B are perspective and cross-sectional side views, respectively, of an example all-around gate transistor 120 including a wire 136 that may include a channel material 102 and a transistor gate stack 104 over a portion of the wire 136, in accordance with various embodiments. The transistor gate stack 104 is only shown in FIG. 11B, but not shown in FIG. 11A in order to not clutter the drawing. In the all-around gate transistor 120 illustrated in FIGS. 11A and 11B, a wire 136 formed of a semiconductor material may extend above a support 134 and a layer of oxide material 130. The support 134 may be any structure from over which the wire 136 may extend; descriptions provided for the support 122 are applicable to the support 134. The wire 136 may take the form of a nanowire or nanoribbon, for example. The transistor 120 of FIGS. 11A and 11B may further include a channel material 102 in the wire 136, and a transistor gate stack 104 including the gate insulator material 106, the gate electrode material 108, the additional gate insulator material 110, and the additional gate electrode material 112. Some or all layers of the transistor gate stack 104 may wrap entirely or almost entirely around the wire 136, with the channel material 102 corresponding to the portion of the wire 136 wrapped by the transistor gate stack 104. In some embodiments, some or all layers of the transistor gate stack 104 may fully encircle the wire 136. For example, as shown in FIG. 11B, the gate insulator material 106 and the gate electrode material 108 may wrap entirely or almost entirely around the wire 136, while the additional gate insulator material 110 and the additional gate electrode material 112 may only be provided on one side of (i.e., not wrap around) the wire 136. However, in other embodiments, the additional gate insulator material 110 and/or the additional gate electrode material 112 may also wrap entirely or almost entirely around the wire 136. The wire 136 may include an S/D contact 116 and an S/D contact 118 on either side of the transistor gate stack 104, as shown. The composition of the channel material 102, the S/D contact 116, and the S/D contact 118 may take the form of any of the embodiments disclosed herein, or known in the art. Although the wire 136 illustrated in FIGS. 11A and 11B is shown as having a rectangular cross-section, the wire 136 may instead have a cross-section that is rounded or otherwise irregularly shaped, and the transistor gate stack 104 may conform to the shape of the wire 136. In use, the tri-gate transistor 120 may form conducting channels on more than three "sides" of the wire 136, potentially improving performance relative to tri-gate transistors. Although FIGS. 11A and 11B depict an embodiment in which the longitudinal axis of the wire 136 runs substantially parallel to a plane of the oxide material 130 (and a plane of the support 134), this need not be the case; in other embodiments, for example, the wire 136 may be oriented "vertically" to be perpendicular to a plane of the oxide material 130 (or plane of the support 134).

FIGS. 12A-12F illustrate cross-sectional side views and top-down views of example IC structures 100 with transistor arrangements with programmable gates for threshold voltage tuning, according to some embodiments of the present disclosure. FIGS. 12A-12F illustrate cross-sectional side views of y-z planes of the coordinate system 105, illustrating examples of views of a transverse cross-section of the wire 136 (i.e., a cross-section in a plane perpendicular to the longitudinal axis of the wire 136), in case the channel material 102 is implemented within the wire 136. However, descriptions provided for FIGS. 12A-12F are equally applicable to transistors of other architectures, e.g., to any other transistor 120 described herein. More generally, FIGS. 12A-12F illustrate cross-sectional side views of the channel material 102 in a plane that is perpendicular to the direction of the gate length of a transistor (e.g., any of the transistors 120 discussed herein).

A number of elements referred to in the description of FIGS. 12A-12F with reference numerals are illustrated in these figures with different patterns, with a legend showing the correspondence between the reference numerals and patterns being provided at the bottom of each drawing page containing FIGS. 12A-12F. For example, the legend illustrates that FIGS. 12A-12F use different patterns to show a channel material 102-1 and a channel material 102-2, a gate electrode material 108-1 and a gate electrode material 108-2, a gate insulator material 106, and so on. Furthermore, although a certain number of a given element may be illustrated in some of FIGS. 12A-12F (e.g., two stacks 205 of nanoribbons 236, with four nanoribbons 236 in each stack 205), this is simply for ease of illustration, and more, or less, than that number may be included in other transistor arrangements with programmable gates according to various embodiments of the present disclosure. Still further, various views shown in FIGS. 12A-12F are intended to show relative arrangements of various elements therein, and various IC structures implementing transistor arrangements with programmable gates, or portions thereof, may include other elements or components that are not illustrated (e.g., transistor portions, various components that may be in electrical contact with any of the transistor portions, etc.).

Each of FIGS. 12A-12F illustrates a first stack 205-1 of a plurality of nanoribbons 236 and a second stack 205-2 of a plurality of nanoribbons 236. Each of the nanoribbons 236 of the two stacks 205 may be an example of the wire 136, described above, but where multiple wires 136 are stacked above one another to form the first stack 205-1 and the second stack 205-2. The first stack 205-1 may be used to implement an N-type transistor, while the second stack 205-2 may be used to implement a P-type transistor, or vice versa. As described above, the channel material 102 and/or the gate electrode material 108 may be different depending on whether a transistor is an N-type transistor or a P-type transistor. That is why FIGS. 12A-12F illustrate that the first stack 205-1 may include a channel material 102-1 and a gate electrode material 108-1, while the second stack 205-2 may include a channel material 102-2 and a gate electrode material 108-2, indicating that, in general, material compositions of the channel materials 102 of the two stacks 205 may be different from one another and/or material compositions of the gate electrode materials 108 of the two stacks 205 may be different from one another. For example, the channel material 102-1 may include any of the channel materials 102 described above for the N-type transistor embodiments and the gate electrode material 108-1 may include any of the gate electrode materials 108 described above for the N-type transistor embodiments, while the channel material 102-2 may include any of the channel materials 102 described above for the P-type transistor embodiments and the gate electrode material 108-2 may include any of the gate electrode materials 108 described above for the P-type transistor embodiments, or vice versa.

FIGS. 12A-12F further illustrate an insulator material 150 that may surround at least portions of the two stacks 205 in order to provide electrical isolation between the two stacks 205 and from either one of the two stacks 205 to other components (not shown). The insulator material 150 may include any of the gate spacer or ILD materials described above.

FIG. 12A illustrates an embodiment where a single layer of the additional gate insulator material 110 may be provided at the bottom of the two stacks 205, and a single layer of the additional gate electrode material 112 may be provided at the bottom of the additional gate insulator material 110. FIG. 12B illustrates an embodiment where a single layer of the additional gate insulator material 110 may be provided over the top of the two stacks 205, and a single layer of the additional gate electrode material 112 may be provided over the top of the additional gate insulator material 110. FIG. 12C illustrates an embodiment where a single, materially continuous, layer of the additional gate insulator material 110 may enclose both of the two stacks 205, and a single, materially continuous, layer of the additional gate electrode material 112 may enclose both of the two stacks 205 over the additional gate insulator material 110. For the embodiments of FIGS. 12A-12C, the gate insulator material 106 wrapping around the nanoribbons 236 of the first stack 205-1, the gate electrode material 108-1, a portion of the additional gate insulator material 110 in contact with the gate electrode material 108-1, and a portion of the additional gate electrode material 112 in contact with the additional gate insulator material 110 form a transistor gate stack 104 of a transistor formed by the nanoribbons 236 of the first stack 205-1. Similarly, the gate insulator material 106 wrapping around the nanoribbons 236 of the second stack 205-2, the gate electrode material 108-2, a portion of the additional gate insulator material 110 in contact with the gate electrode material 108-2, and a portion of the additional gate electrode material 112 in contact with the additional gate insulator material 110 form a transistor gate stack 104 of a transistor formed by the nanoribbons 236 of the second stack 205-2. For the embodiments of FIGS. 12A-12C, threshold voltage for both of the stacks 205 may be tuned simultaneously by applying signals (e.g., voltage) to the single layer of the additional gate electrode material 112. On the other hand, turning on and off of the transistor formed by the nanoribbons 236 of the first stack 205-1 and the transistor formed by the nanoribbons 236 of the second stack 205-2 may be performed separately by applying respective signals (e.g., respective voltages) to the gate electrode material 108-1 provided as part of the transistor gate stack 104 of the first stack 205-1 and to the gate electrode material 108-2 provided as part of the transistor gate stack 104 of the second stack 205-2.

In contrast to the embodiments of FIGS. 12A-12C, FIGS. 12D-12E illustrate embodiments where separate (i.e., not materially continuous) layers of the additional gate insulator material 110 and separate layers of the additional gate electrode material 112 may be provided for the first stack 205-1 and the second stack 205-2. For the embodiment of FIG. 12D, the gate insulator material 106 wrapping around the nanoribbons 236 of the first stack 205-1, the gate electrode material 108-1, a portion of the additional gate insulator material 110 in contact with the gate electrode material 108-1 (e.g., provided on the side of the first stack 205-1, as shown in FIG. 12D), and a portion of the additional gate electrode material 112 in contact with the portion of the additional gate insulator material 110 in contact with the gate electrode material 108-1 form a transistor gate stack 104 of a transistor formed by the nanoribbons 236 of the first stack 205-1. Similarly, the gate insulator material 106 wrapping around the nanoribbons 236 of the second stack 205-2, the gate electrode material 108-2, a portion of the additional gate insulator material 110 in contact with the gate electrode material 108-2 (e.g., provided on the side of the second stack 205-2, as shown in FIG. 12D), and a portion of the additional gate electrode material 112 in contact with the portion of the additional gate insulator material 110 in contact with the gate electrode material 108-2 form a transistor gate stack 104 of a transistor formed by the nanoribbons 236 of the second stack 205-2.

The embodiment shown in FIG. 12E is similar to that of FIG. 12A, but illustrating a respective arrangement of the additional gate insulator material 110 and the additional gate electrode material 112 for each of the first stack 205-1 and the second stack 205-2. The embodiment shown in FIG. 12F is similar to that of FIG. 12C, but also illustrating a respective arrangement of the additional gate insulator material 110 and the additional gate electrode material 112 for each of the first stack 205-1 and the second stack 205-2. Although not specifically shown in the present drawings, analogous applies to modifying the embodiment of FIG. 12B to provide a respective arrangement of the additional gate insulator material 110 and the additional gate electrode material 112 for each of the first stack 205-1 and the second stack 205-2.

Thus, different to the embodiments of FIGS. 12A-12C, for the embodiments of FIGS. 12D-12E, threshold voltages for the stacks 205 may be tuned separately by applying respective signals (e.g., respective voltages) to the additional gate electrode material 112 provided as part of the transistor gate stack 104 of the first stack 205-1 and to the additional gate electrode material 112 provided as part of the transistor gate stack 104 of the second stack 205-2. Similarly to the embodiments of FIGS. 12A-12C, for the embodiments of FIGS. 12D-12E, turning on and off of the transistor formed by the nanoribbons 236 of the first stack 205-1 and the transistor formed by the nanoribbons 236 of the second stack 205-2 may be performed separately by applying respective signals (e.g., respective voltages) to the gate electrode material 108-1 provided as part of the transistor gate stack 104 of the first stack 205-1 and to the gate electrode material 108-2 provided as part of the transistor gate stack 104 of the second stack 205-2.

Various other embodiments of how the additional gate insulator material 110 and the additional gate electrode material 112 may be provided for a plurality of transistors (e.g., any of the transistor 120 described herein) are possible and within the scope of the present disclosure.

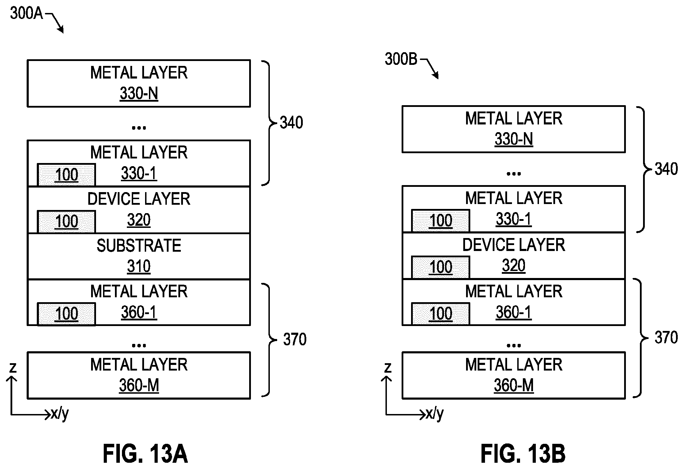

FIGS. 13A-13B provide schematic illustrations of microelectronic assemblies 300 in which IC structures 100 with transistor arrangements with programmable gates for threshold voltage tuning may be implemented, according to some embodiments of the present disclosure. In general, the IC structures 100 according to any embodiments described herein may be implemented as part of front-end-of-line (FEOL) layer, as part of back-end-of-line (BEOL) layers and may be provided either on the front side or on the back side of the FEOL layer.

FEOL and BEOL are two distinct stages in semiconductor manufacturing (e.g., in advanced complementary metal-oxide-semiconductor (CMOS) processes), each playing an important role in the fabrication of IC structures (or, more generally, of semiconductor devices). These terms refer to the chronological order of processes involved in creating an IC structure. The FEOL processes occur at the front or early stages of semiconductor manufacturing, typically on the surface of a semiconductor (e.g., silicon) wafer. In the FEOL, individual semiconductor devices components (e.g., transistor, capacitors, resistors, etc.) can be patterned in a wafer. In the BEOL, interconnect structures such as conductive lines and conductive vias, separated as needed by an insulator material, can be formed to provide connection between individual components. The BEOL usually starts with forming the first metal layer on the wafer. The first metal layer is often called M0. More metal layers can be formed on top of M0, and these metal layers are often called M1, M2, and so on. The BEOL layers comprising interconnect structures separated by an insulator material are typically referred to as "backend layers." The BEOL layers provided on top of the FEOL layer may be described as being provided on the "front side" of a microelectronic assembly, while the BEOL layers provided on the back of the FEOL layer may be described as being provided on the "back side" of a microelectronic assembly.

FIG. 13A illustrates a cross-sectional view of an example microelectronic assembly 300A in which one or more IC structures 100 with transistor arrangements with programmable gates for threshold voltage tuning may be implemented, according to some embodiments of the present disclosure. As shown in FIG. 13A, in general, the microelectronic assembly 300A may include a substrate 310, a device layer 320, and one or more (e.g., a plurality) of metal layers 330, individually labeled as a metal layer 330-1 through metal layer 330-N, where N is an integer greater than 1. Together, the metal layers 330 may be referred to as a metallization stack 340. As also shown in FIG. 13, the microelectronic assembly 300A may further include one or more (e.g., a plurality) of metal layers 360, individually labeled as a metal layer 360-1 through a metal layer 360-M, where M is an integer equal to or greater than 1 and may, but does not have to be, equal to N. Together, the metal layers 360 may be referred to as a metallization stack 370. The side of the substrate 310 on which the device layer 320 is provided is typically referred to as a "front side," and the other side of the substrate 310 is referred to as a "back side." Thus, the device layer 320 and the metal layers 330 are frontside layers, while the metal layers 360 are backside layers. As shown in FIG. 13A, the substrate 310 may be between the device layer 320 on the front side and the metal layers 360 on the back side, and the device layer 320 may be between the substrate 310 and the metallization stack 340.

The illustration of FIG. 13A is intended to provide a general orientation and arrangement of various layers with respect to one another, and, unless specified otherwise in the present disclosure, includes embodiments of the microelectronic assembly 300A where portions of elements described with respect to one of the layers shown in FIG. 13A may extend into one or more, or be present in, other layers. Same applies to other drawings. In other embodiments, the metallization stack 340 and/or the metallization stack 370 may be absent from the microelectronic assembly 300A.

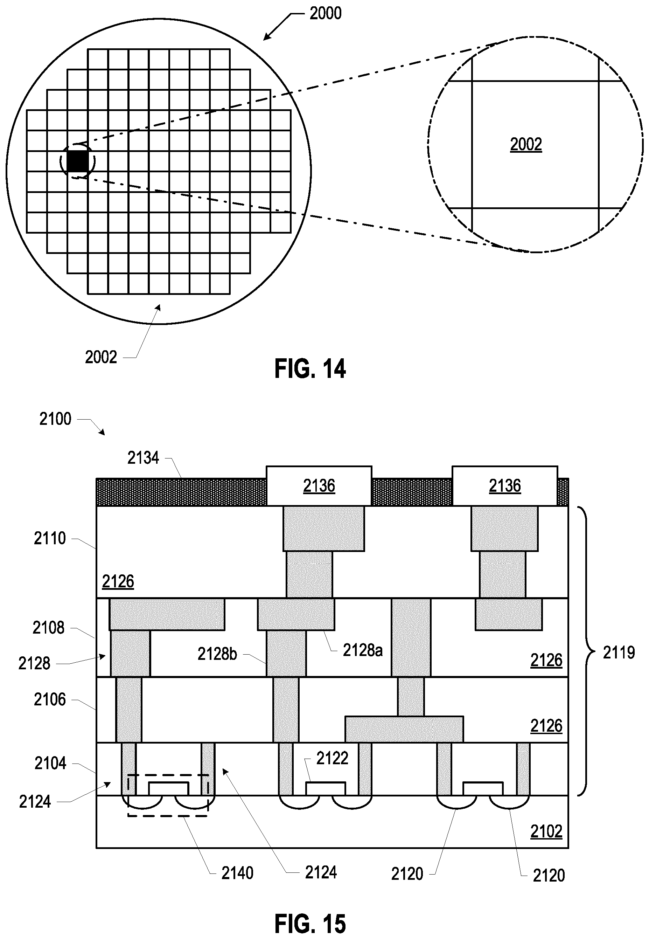

The substrate 310 may be any suitable support over which the device layer 320 and the metallization stack 340 may be provided. For example, the substrate 310 may be a die, a wafer, a chip, or any other suitable support structure. The substrate 310 may, e.g., be the wafer 2000 of FIG. 14, discussed below, and may be, or be included in, a die, e.g., the singulated die 2002 of FIG. 14, discussed below. The substrate 310 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the substrate 310 may be a printed circuit board (PCB) substrate. Although a few examples of materials from which the substrate may be formed are described here, any material that may serve as a foundation upon which a device layer 320 may be built falls within the spirit and scope of the present disclosure. Any of the descriptions provided for the substrate 310 are applicable to any of the support 122, the support 134, or the base 140, and vice versa.

The device layer 320 may include any combination of components (e.g., ICs) provided over the substrate 310. For example, in some embodiments, the device layer 320 may include various logic layers, circuits, and devices (e.g., logic transistors) to drive and control a logic IC. In some embodiments, the device layer 320 may include memory devices/circuits. The device layer 320 may also be referred to as a "FEOL layer" and the components of the device layer 320 (e.g., transistors) may be referred to as "frontend components."

Various layers of the metallization stack 340 may be, or include, BEOL layers, which may also be referred to as "backend layers." As used herein, the term "metal layer" may refer to a layer that includes electrically conductive interconnect structures (e.g., conductive lines and conductive vias) for providing electrical connectivity between different IC components, e.g., between different components of the device layer 320. Metal layers described herein may also be referred to as "metal" layers to indicate that these layers include electrically conductive interconnect structures which may, but do not have to, be metal. Various metal layers of the metallization stack 340 may be used to interconnect the various inputs and outputs of the active components (e.g., transistors) in the device layer 320. Generally speaking, each of the metal layers of the metallization stack 340 may include a conductive line (also sometimes referred to as a "trench," a "trace," or a "metal line") and/or a conductive via. Conductive lines of a metal layer are interconnects configured for transferring signals and power along electrically conductive (e.g., metal) structures extending in the x-y plane (e.g., in the x or y directions), while the conductive vias of a metal layer are configured for transferring signals and power through electrically conductive structures extending in the z-direction, e.g., to any of the adjacent metal layers above or below. Accordingly, conductive vias connect interconnect structures (e.g., conductive lines and/or conductive vias) of one metal layer to interconnect structures of an adjacent metal layer. While referred to as "metal" layers, various layers of the metallization stack 340 may include only certain patterns of conductive metals, e.g., copper (Cu), aluminum (Al), tungsten (W), or cobalt (Co), or metal alloys, or more generally, patterns of an electrically conductive material, formed in a medium of an insulator material such as an ILD. The insulator medium may include any suitable ILD materials such as silicon oxide, carbon-doped silicon oxide, silicon carbide, silicon nitride, aluminum oxide, and/or silicon oxynitride.

Various layers of the metallization stack 370 may be, or include, BEOL layers on the back side of the substrate 310, which may also be referred to as "backside backend layers." Descriptions provided with respect to the metal layers 330 and the metallization stack 340 are applicable to, respectively, the metal layers 360 and the metallization stack 370 and, in the interest of brevity, are not repeated.

As shown in FIG. 13A, in various embodiments, any of the IC structures 100 with transistor arrangements with programmable gates for threshold voltage tuning may be provided in one or more of the device layer 320 and/or any one or more of the metal layers 330-1 and 330-N of the metallization stack 340 and/or any one or more of the metal layers 360-1 and 360-M of the metallization stack 370.

FIG. 13B illustrates a cross-sectional view of an example microelectronic assembly 300B in which one or more IC structures 100 with transistor arrangements with programmable gates for threshold voltage tuning may be implemented, according to some embodiments of the present disclosure. The microelectronic assembly 300B is similar to the microelectronic assembly 300A except that, in the microelectronic assembly 300B, once all of the layers on the front side have been fabricated and the microelectronic assembly 300B has been flipped over to continue with fabrication of the metal layers 360 on the back side, the substrate 310 may be thinned (e.g., polished, etched, or otherwise removed) to the point that terminals of the components of the device layer 320 (e.g., S/D regions of the transistors in the device layer 320) may be contacted from the back side. The metal layers 360 may then be provided directly over the back side of the device layer 320. Thus, as shown in FIG. 13B, the substrate 310 may be substantially removed (but the portions of the substrate 310 in which the frontend devices of the device layer 320 were fabricated remain), and the device layer 320 may be between the metal layers 330 on the front side and the metal layers 360 on the back side. Other descriptions provided with respect to FIG. 13A are applicable to FIG. 13B and, in the interest of brevity, are not repeated.

The IC structures and/or microelectronic assemblies with transistor arrangements with programmable gates for threshold voltage tuning disclosed herein (e.g., any of the IC structures described with reference to FIGS. 1-12 or any of the microelectronic assemblies described with reference to FIGS. 13A-13B) may be included in any suitable electronic device. FIGS. 14-19 illustrate various examples of apparatuses that may include one or more IC structures and/or microelectronic assemblies with transistor arrangements with programmable gates for threshold voltage tuning disclosed herein, e.g., with any embodiment of the transistor gate stacks 104, any embodiment of the IC structures 100 as shown in FIGS. 2-12 or any embodiment of the microelectronic assemblies 300 as shown in FIGS. 13A-13B, or any combination of such embodiments.

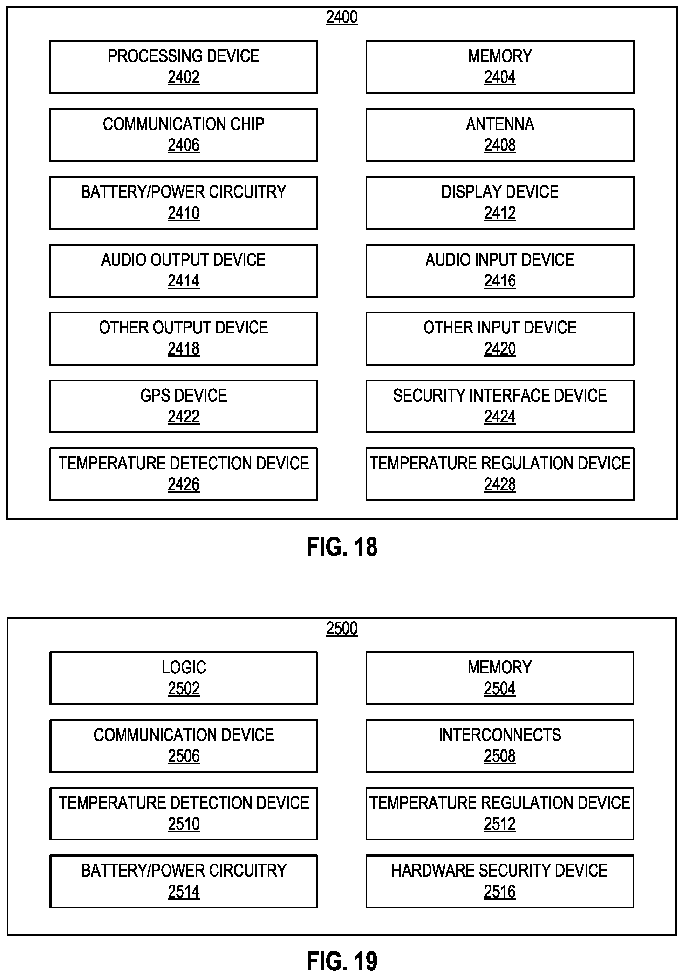

FIG. 14 illustrates top views of a wafer and dies that may include one or more IC structures and/or microelectronic assemblies with transistor arrangements with programmable gates for threshold voltage tuning in accordance with any of the embodiments disclosed herein. The wafer 2000 may be composed of semiconductor material and may include one or more dies 2002 having IC structures formed on a surface of the wafer 2000. Each of the dies 2002 may be a repeating unit of a semiconductor product that includes any suitable IC structure (e.g., any of the IC structures and/or microelectronic assemblies described with reference to FIGS. 1-13). After the fabrication of the semiconductor product is complete (e.g., after manufacture of one or more IC structures 100 and/or after manufacture of one or more microelectronic assemblies 300 as described herein), the wafer 2000 may undergo a singulation process in which each of the dies 2002 is separated from one another to provide discrete "chips" of the semiconductor product. In particular, devices that include one or more IC structures and/or microelectronic assemblies with transistor arrangements with programmable gates for threshold voltage tuning as disclosed herein may take the form of the wafer 2000 (e.g., not singulated) or the form of the die 2002 (e.g., singulated). The die 2002 may include one or more transistor arrangements with programmable gates for threshold voltage tuning (e.g., any of the transistors 120 of FIGS. 2-12, discussed above, or any of the transistors 2140 of FIG. 15, discussed below), and/or supporting circuitry to route electrical signals to the transistor arrangements, as well as any other IC components. In some embodiments, the wafer 2000 or the die 2002 may include a memory device (e.g., a memory device with one or more transistor arrangements with programmable gates for threshold voltage tuning), a logic device (e.g., an AND, OR, NAND, or NOR gate, or any other logic device with one or more transistor arrangements with programmable gates for threshold voltage tuning), or any other suitable circuit element. Multiple ones of these devices may be combined on a single die 2002. For example, a memory array formed by multiple memory devices may be formed on a same die 2002 as a processing device (e.g., the processing device 2500 of FIG. 19) or other logic that is configured to store information in the memory devices or execute instructions stored in the memory array.

FIG. 15 is a side, cross-sectional view of an IC device 2100 that may include one or more IC structures and/or microelectronic assemblies with transistor arrangements with programmable gates for threshold voltage tuning as described herein, in accordance with various embodiments. For example, a gate 2122 of any of the transistors 2140 of the IC device 2100 may include a transistor gate stack 104 as described herein. In another example, any of the transistors 2140 may be implemented as any of the transistors of FIGS. 2-12. In yet another example, one or more of the IC devices 2100 may be included in one or more dies 2002 of FIG. 14. The IC device 2100 may be formed on a substrate 2102 (e.g., the wafer 2000 of FIG. 14) and may be included in a die (e.g., the die 2002 of FIG. 14). The substrate 2102 may take on any forms of the support 122, the base 140, the support 134, or the substrate 310, described above.

The IC device 2100 may include one or more device layers 2104 disposed on the substrate 2102. The device layer 2104 may include features of one or more transistors 2140 (e.g., metal-oxide-semiconductor field-effect transistors (MOSFETs)) formed on the substrate 2102. The device layer 2104 may include, for example, one or more S/D regions 2120, a gate 2122 to control current flow in the transistors 2140 between the S/D regions 2120, and one or more S/D contacts 2124 (e.g., any of the S/D contacts 116 or 118, described above) to route electrical signals to/from the S/D regions 2120. The transistors 2140 may include additional features not depicted for the sake of clarity, such as device isolation regions, gate contacts, and the like. The transistors 2140 are not limited to the type and configuration depicted in FIG. 15 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors. In some embodiments, any of the transistors 2140 may be implemented as any of the transistors 120, described above.

Each transistor 2140 may include a gate 2122 formed of at least two layers, a gate insulator and a gate electrode. The gate 2122 of at least some of the transistors 2140 may be include a transistor gate stack 104 as described above.

The S/D regions 2120 may be formed within the substrate 2102 adjacent to the gate 2122 of each transistor 2140. The S/D regions 2120 may be formed using an implantation/diffusion process or an etching/deposition process, for example. In the former process, dopants such as boron, aluminum, antimony, phosphorous, or arsenic may be ion-implanted into the substrate 2102 to form the S/D regions 2120. An annealing process that activates the dopants and causes them to diffuse farther into the substrate 2102 may follow the ion-implantation process. In the latter process, the substrate 2102 may first be etched to form recesses at the locations of the S/D regions 2120. An epitaxial deposition process may then be carried out to fill the recesses with material that is used to fabricate the S/D regions 2120. In some implementations, the S/D regions 2120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2120 may be formed using one or more alternate semiconductor materials such as germanium or a group III-V material or alloy. In further embodiments, one or more layers of metal and/or metal alloys may be used to form the S/D regions 2120.

Electrical signals, such as power and/or input/output (I/O) signals, may be routed to and/or from the devices (e.g., the transistors 2140) of the device layer 2104 through one or more interconnect layers disposed on the device layer 2104 (illustrated in FIG. 15 as interconnect layers 2106, 2108, and 2110). For example, electrically conductive features of the device layer 2104 (e.g., the gate 2122 and the S/D contacts 2124) may be electrically coupled with the interconnect structures 2128 of the interconnect layers 2106, 2108, and 2110. The one or more interconnect layers 2106, 2108, and 2110 may form a metallization stack (also referred to as an "ILD stack") 2119 of the IC device 2100. Descriptions provided with respect to the device layer 320 are applicable to the device layer 2104 and vice versa. Furthermore, descriptions provided with respect to the metal layers 330 or the metal layers 360 are applicable to the interconnect layers 2106, 2108, and 2110 and vice versa.

The interconnect structures 2128 may be arranged within the interconnect layers 2106, 2108, and 2110 to route electrical signals according to a wide variety of designs (in particular, the arrangement is not limited to the particular configuration of interconnect structures 2128 depicted in FIG. 15). Although a particular number of interconnect layers 2106, 2108, and 2110 is depicted in FIG. 15, embodiments of the present disclosure include IC devices having more or fewer interconnect layers than depicted.

In some embodiments, the interconnect structures 2128 may include lines 2128a and/or vias 2128b filled with an electrically conductive material such as a metal. The lines 2128a may be arranged to route electrical signals in a direction of a plane that is substantially parallel with a surface of the substrate 2102 upon which the device layer 2104 is formed. For example, the lines 2128a may route electrical signals in a direction in and out of the page from the perspective of FIG. 15. The vias 2128b may be arranged to route electrical signals in a direction of a plane that is substantially perpendicular to the surface of the substrate 2102 upon which the device layer 2104 is formed. In some embodiments, the vias 2128b may electrically couple lines 2128a of different interconnect layers 2106, 2108, and 2110 together.

The interconnect layers 2106, 2108, and 2110 may include an insulator material 2126 disposed between the interconnect structures 2128, as shown in FIG. 15. In some embodiments, the insulator material 2126 disposed between the interconnect structures 2128 in different ones of the interconnect layers 2106, 2108, and 2110 may have different compositions; in other embodiments, the composition of the insulator material 2126 between different interconnect layers 2106, 2108, and 2110 may be the same.

A first interconnect layer 2106 may be formed above the device layer 2104. In some embodiments, the first interconnect layer 2106 may include lines 2128a and/or vias 2128b, as shown. The lines 2128a of the first interconnect layer 2106 may be coupled with contacts (e.g., the S/D contacts 2124) of the device layer 2104.

A second interconnect layer 2108 may be formed above the first interconnect layer 2106. In some embodiments, the second interconnect layer 2108 may include vias 2128b to couple the lines 2128a of the second interconnect layer 2108 with the lines 2128a of the first interconnect layer 2106. Although the lines 2128a and the vias 2128b are structurally delineated with a line within each interconnect layer (e.g., within the second interconnect layer 2108) for the sake of clarity, the lines 2128a and the vias 2128b may be structurally and/or materially contiguous (e.g., simultaneously filled during a dual-damascene process) in some embodiments.

A third interconnect layer 2110 (and additional interconnect layers, as desired) may be formed in succession on the second interconnect layer 2108 according to similar techniques and configurations described in connection with the second interconnect layer 2108 or the first interconnect layer 2106. In some embodiments, the interconnect layers that are "higher up" in the metallization stack 2119 in the IC device 2100 (i.e., farther away from the device layer 2104) may be thicker.

The IC device 2100 may include a solder resist material 2134 (e.g., polyimide or similar material) and one or more conductive contacts 2136 formed on the interconnect layers 2106, 2108, and 2110. In FIG. 15, the conductive contacts 2136 are illustrated as taking the form of bond pads. The conductive contacts 2136 may be electrically coupled with the interconnect structures 2128 and configured to route the electrical signals of the transistor(s) 2140 to other external devices. For example, solder bonds may be formed on the one or more conductive contacts 2136 to mechanically and/or electrically couple a chip including the IC device 2100 with another component (e.g., a circuit board). The IC device 2100 may include additional or alternate structures to route the electrical signals from the interconnect layers 2106, 2108, and 2110; for example, the conductive contacts 2136 may include other analogous features (e.g., posts) that route the electrical signals to external components.

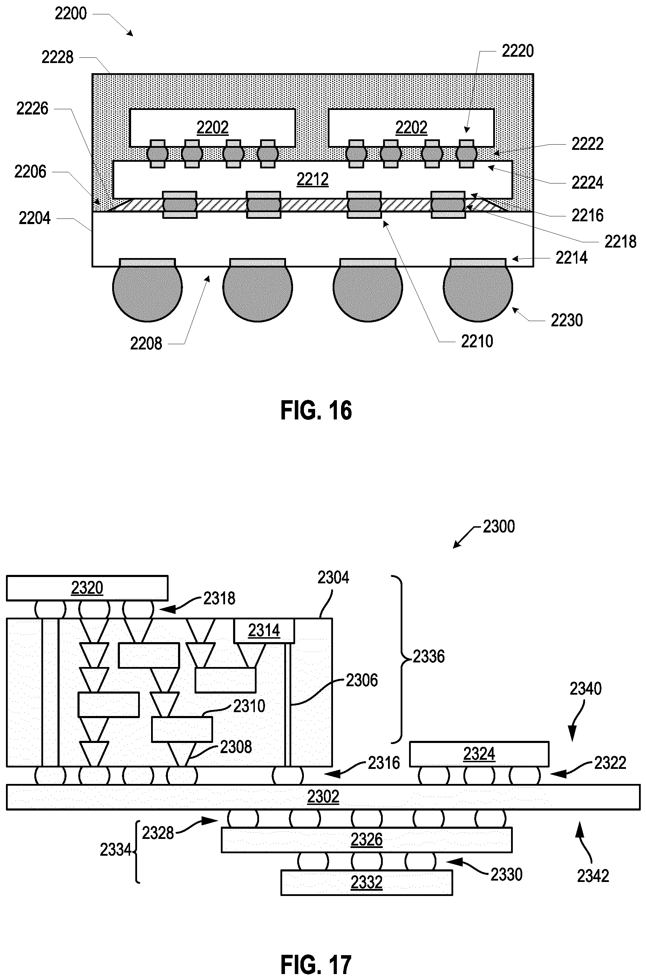

FIG. 16 is a side, cross-sectional view of an example IC package 2200 that may include one or more IC structures and/or microelectronic assemblies with transistor arrangements with programmable gates for threshold voltage, in accordance with various embodiments. For example, in some embodiments, the dies 2202 may include one or more IC structures and/or microelectronic assemblies with any of the transistor arrangements with programmable gates for threshold voltage described herein. In another example, in some embodiments, any of the dies 2202 of the IC package 2200 may be implemented as the die 2002 of FIG. 14. In some embodiments, the dies 2202 may include any of the embodiments of the IC device 2100. In embodiments in which the IC package 2200 includes multiple dies 2202, the IC package 2200 may be referred to as a multi-chip package (MCP). The dies 2202 may include circuitry to perform any desired functionality. For example, or more of the dies 2202 may be logic dies (e.g., silicon-based dies), and one or more of the dies 2202 may be memory dies (e.g., high bandwidth memory). In some embodiments, the IC package 2200 may be a system-in-package (SiP). In some embodiments, the IC package 2200 may include a photonics IC (PIC) co-packaged with an IC package. In some embodiments, the IC package 2200 may include fully integrated electronic photonics ICs (EPICs).

The IC package 2200 may include a package substrate 2204 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 2206 and the face 2208, or between different locations on the face 2206, and/or between different locations on the face 2208. These conductive pathways may take the form of any of the interconnect structures 2128 discussed above with reference to FIG. 15.

The package substrate 2204 may include conductive contacts 2210 that are coupled to conductive pathways (not shown) through the package substrate 2204, allowing circuitry within the dies 2202 and/or the interposer 2212 to electrically couple to various ones of the conductive contacts 2214 (or to other devices included in the package substrate 2204, not shown). The IC package 2200 may include an interposer 2212 coupled to the package substrate 2204 via conductive contacts 2216 of the interposer 2212, first-level interconnects 2218, and the conductive contacts 2210 of the package substrate 2204. The first-level interconnects 2218 illustrated in FIG. 16 are solder bumps, but any suitable first-level interconnects 2218 may be used. In some embodiments, no interposer 2212 may be included in the IC package 2200; instead, the dies 2202 may be coupled directly to the conductive contacts 2210 at the face 2206 by first-level interconnects 2218. Generally, one or more dies 2202 may be coupled to the package substrate 2204 via any suitable structure (e.g., a silicon bridge, an organic bridge, one or more waveguides, one or more interposers, wirebonds, etc.).

The IC package 2200 may include one or more dies 2202 coupled to the interposer 2212 via conductive contacts 2220 of the dies 2202, first-level interconnects 2222, and conductive contacts 2224 of the interposer 2212. The conductive contacts 2224 may be coupled to conductive pathways (not shown) through the interposer 2212, allowing circuitry within the dies 2202 to electrically couple to various ones of the conductive contacts 2216 (or to other devices included in the interposer 2212, not shown). The first-level interconnects 2222 illustrated in FIG. 16 are solder bumps, but any suitable first-level interconnects 2222 may be used. For example, the first-level interconnects 2222 may include hybrid bonding interconnects. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 2226 may be disposed between the package substrate 2204 and the interposer 2212 around the first-level interconnects 2218, and a mold compound 2228 may be disposed around the dies 2202 and the interposer 2212 and in contact with the package substrate 2204. In some embodiments, the underfill material 2226 may be the same as the mold compound 2228. Example materials that may be used for the underfill material 2226 and the mold compound 2228 are epoxy mold materials, as suitable. Second-level interconnects 2230 may be coupled to the conductive contacts 2214. The second-level interconnects 2230 illustrated in FIG. 16 are solder balls (e.g., for a ball grid array arrangement), but any suitable second-level interconnects 2230 may be used (e.g., pins in a pin grid array arrangement or lands in a land grid array arrangement). The second-level interconnects 2230 may be used to couple the IC package 2200 to another component, such as a circuit board (e.g., a motherboard), an interposer, or another IC package, as known in the art and as discussed below with reference to FIG. 17.

Although the IC package 2200 illustrated in FIG. 16 is a flip chip package, other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fanout (FO) package. Although two dies 2202 are illustrated in the IC package 2200 of FIG. 16, an IC package 2200 may include any desired number of dies 2202. An IC package 2200 may include additional passive components, such as surface-mount resistors, capacitors, and inductors disposed on the first face 2206 or the second face 2208 of the package substrate 2204, or on either face of the interposer 2212. More generally, an IC package 2200 may include any other active or passive components known in the art.

FIG. 17 is a side, cross-sectional view of an IC device assembly 2300 that may include one or more IC packages or other electronic components (e.g., a die) including one or more IC structures and/or microelectronic assemblies with transistor arrangements with programmable gates for threshold voltage tuning in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. Any of the IC packages discussed below with reference to the IC device assembly 2300 may take the form of any of the embodiments of the IC package 2200 discussed above with reference to FIG. 16.

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 17 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302 and may include solder balls (as shown in FIG. 17), male and female portions of a socket, an adhesive, an underfill material, and/or any other suitable electrical and/or mechanical coupling structure.

The package-on-interposer structure 2336 may include an IC package 2320 coupled to a package interposer 2304 by coupling components 2318. The coupling components 2318 may take any suitable form for the application, such as the forms discussed above with reference to the coupling components 2316. Although a single IC package 2320 is shown in FIG. 17, multiple IC packages may be coupled to the package interposer 2304; indeed, additional interposers may be coupled to the package interposer 2304. The package interposer 2304 may provide an intervening substrate used to bridge the circuit board 2302 and the IC package 2320. The IC package 2320 may be or include, for example, a die (the die 2002 of FIG. 14), an IC device (e.g., the IC device 2100 of FIG. 15), or any other suitable component. Generally, the package interposer 2304 may spread a connection to a wider pitch or reroute a connection to a different connection. For example, the package interposer 2304 may couple the IC package 2320 (e.g., a die) to a set of BGA conductive contacts of the coupling components 2316 for coupling to the circuit board 2302. In the embodiment illustrated in FIG. 17, the IC package 2320 and the circuit board 2302 are attached to opposing sides of the package interposer 2304; in other embodiments, the IC package 2320 and the circuit board 2302 may be attached to a same side of the package interposer 2304. In some embodiments, three or more components may be interconnected by way of the package interposer 2304. In some embodiments, the IC package 2320 may include one or more IC structures and/or microelectronic assemblies with transistor arrangements with programmable gates for threshold voltage tuning as disclosed herein.

In some embodiments, the package interposer 2304 may be formed as a PCB, including multiple metal layers separated from one another by layers of dielectric material and interconnected by electrically conductive vias. In some embodiments, the package interposer 2304 may be formed of an epoxy resin, a fiberglass-reinforced epoxy resin, an epoxy resin with inorganic fillers, a ceramic material, or a polymer material such as polyimide. In some embodiments, the package interposer 2304 may be formed of alternate rigid or flexible materials that may include the same materials described above for use in a semiconductor substrate, such as silicon, germanium, and other group III-V and group IV materials. The package interposer 2304 may include metal lines 2310 and vias 2308, including but not limited to through-silicon vias (TSVs) 2306. The package interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 17 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 18 is a block diagram of an example computing device 2400 that may include one or more components including one or more IC structures and/or microelectronic assemblies with transistor arrangements with programmable gates for threshold voltage tuning in accordance with any of the embodiments disclosed herein. For example, any suitable ones of the components of the computing device 2400 may include a die (e.g., the die 2002 of FIG. 14) having one or more IC structures and/or microelectronic assemblies with transistor arrangements with programmable gates for threshold voltage tuning as described herein. Any one or more of the components of the computing device 2400 may include an IC device 2100 of FIG. 15, an IC package 2200 of FIG. 16, or an IC device assembly 2300 of FIG. 17.

A number of components are illustrated in FIG. 18 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 18, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414 but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. In some embodiments, the processing device 2402 may include one or more IC structures and/or microelectronic assemblies with transistor arrangements with programmable gates for threshold voltage tuning described herein.

The computing device 2400 may include a memory 2404, which may itself include one or more memory devices such as volatile memory (e.g., DRAM), non-volatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque MRAM. In some embodiments, the memory 2404 may include one or more IC structures and/or microelectronic assemblies with transistor arrangements with programmable gates for threshold voltage tuning as described herein.

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

FIG. 19 is a block diagram of an example processing device 2500 that may include one or more IC structures and/or microelectronic assemblies with transistor arrangements with programmable gates for threshold voltage tuning as described herein. For example, any suitable ones of the components of the processing device 2500 may include a die (e.g., the die 2002 of FIG. 14) having one or more IC structures and/or microelectronic assemblies with transistor arrangements with programmable gates for threshold voltage tuning as described herein. Any one or more of the components of the processing device 2500 may include an IC device 2100 of FIG. 15, an IC package 2200 of FIG. 16, or an IC device assembly 2300 of FIG. 17. Any one or more of the components of the processing device 2500 may include, or be included in, a computing device 2400 of FIG. 18; for example, the processing device 2500 may be the processing device 2402 of the computing device 2400.

A number of components are illustrated in FIG. 19 as included in the processing device 2500, but any one or more of these components may be omitted or duplicated, as suitable for the application. In some embodiments, some or all of the components included in the processing device 2500 may be attached to one or more motherboards. In some embodiments, some or all of these components are fabricated on a single SoC die or coupled to a single support structure, e.g., to a single carrier substrate.

Additionally, in various embodiments, the processing device 2500 may not include one or more of the components illustrated in FIG. 19, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more of input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504. In some embodiments, the logic circuitry 2502 may include one or more IC structures and/or microelectronic assemblies with transistor arrangements with programmable gates for threshold voltage tuning described herein.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 2404 (FIG. 18). In some embodiments, the memory 2504 may be a designated device configured to provide storage functionality for the components of the processing device 2500 (e.g., local), while the memory 2404 may be configured to provide system-level storage functionality for the entire computing device 2400 (e.g., global). In some embodiments, the memory 2504 may include memory that shares a die with the logic circuitry 2502. In some embodiments, the memory 2504 may include one or more memory cells with transistors with programmable gates for threshold voltage tuning described herein.

The processing device 2500 may include a communication device 2506, which may be implemented substantially as described above with reference to the communication chip 2406 (FIG. 18). In some embodiments, the communication device 2506 may be a designated device configured to provide communication functionality for the components of the processing device 2500 (e.g., local), while the communication chip 2406 may be configured to provide system-level communication functionality for the entire computing device 2400 (e.g., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"). In some embodiments, the interconnects 2508 may be implemented as the interconnect structures 2128 of FIG. 15, described above.

The processing device 2500 may include a temperature detection device 2510 which may be implemented substantially as described above with reference to the temperature detection device 2426 of FIG. 18 but configured to determine temperatures on a more local scale, e.g., of the processing device 2500 of components thereof. In some embodiments, the temperature detection device 2510 may be a designated device configured to provide temperature detection functionality for the components of the processing device 2500 (e.g., local), while the temperature detection device 2426 may be configured to provide system-level temperature detection functionality for the entire computing device 2400 (e.g., global).

The processing device 2500 may include a temperature regulation device 2512 which may be implemented substantially as described above with reference to the temperature regulation device 2428 of FIG. 18 but configured to regulate temperatures on a more local scale, e.g., of the processing device 2500 of components thereof. In some embodiments, the temperature regulation device 2512 may be a designated device configured to provide temperature regulation functionality for the components of the processing device 2500 (e.g., local), while the temperature regulation device 2428 may be configured to provide system-level temperature regulation functionality for the entire computing device 2400 (e.g., global).

The processing device 2500 may include a battery/power circuitry 2514 which may be implemented substantially as described above with reference to the battery/power circuitry 2410 of FIG. 18. In some embodiments, the battery/power circuitry 2514 may be a designated device configured to provide battery/power functionality for the components of the processing device 2500 (e.g., local), while the battery/power circuitry 2410 may be configured to provide system-level battery/power functionality for the entire computing device 2400 (e.g., global).

The processing device 2500 may include a hardware security device 2516 which may be implemented substantially as described above with reference to the security interface device 2424 of FIG. 18. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure cryptoprocessors chips.

The following paragraphs provide examples of various ones of the embodiments disclosed herein.

Example 1 provides a transistor that includes a channel material; a first gate electrode material; a first insulator, where the first insulator is between the channel material and the first gate electrode material; a second insulator, where the first gate electrode material is between the first insulator and the second insulator; and a second gate electrode material, where the second insulator is between the first gate electrode material and the second gate electrode material.

Example 2 provides the transistor according to example 1, where the second insulator is a FE material or an AFE material.

Example 3 provides the transistor according to examples 1 or 2, where at least about 5% of the second insulator is in an orthorhombic phase.

Example 4 provides the transistor according to any one of examples 1-3, where at least about 5% of the second insulator is in a tetragonal phase.

Example 5 provides the transistor according to any one of examples 1-4, where at most about 95% of the second insulator is amorphous or in a monoclinic phase.

Example 6 provides the transistor according to example 1, where the second insulator includes silicon and nitrogen.

Example 7 provides the transistor according to example 1, where the second insulator includes a first layer and a second layer, the first layer includes silicon and nitrogen, and the second layer includes silicon and oxygen.

Example 8 provides the transistor according to example 1, where the second insulator includes a charge-trapping layer and a tunnelling layer.

Example 9 provides the transistor according to any one of examples 1 or 6-8, where the second insulator is a charge-trapping insulator.

Example 10 provides the transistor according to any one of examples 1-9, where the second insulator is in contact (e.g., in direct physical contact) with the first gate electrode material.

Example 11 provides the transistor according to any one of examples 1-10, where the second gate electrode material is in contact (e.g., in direct physical contact) with the second insulator.

Example 12 provides the transistor according to any one of examples 1-11, where a thickness of the second insulator is between about 3 nanometers and 25 nanometers.

Example 13 provides the transistor according to any one of examples 1-12, where the channel material is shaped as a nanoribbon, the first insulator wraps around the nanoribbon and the second insulator material does not wrap around the nanoribbon.

Example 14 provides an IC structure that includes a plurality of first nanoribbons stacked above one another; a plurality of second nanoribbons stacked above one another; a first gate at least partially (or fully) wrapping around the plurality of first nanoribbons; a second gate at least partially (or fully) wrapping around the plurality of second nanoribbons; an insulator in contact with at least one of a portion of the first gate and a portion of the second gate; and a third gate in contact with a portion of the insulator, where the insulator includes one of (1) a FE material, (2) an AFE material, or (3) a charge-trapping arrangement.

Example 15 provides the IC structure according to example 14, where the insulator is in contact with both the portion of the first gate and the portion of the second gate.

Example 16 provides the IC structure according to example 15, where the insulator partially wraps around the first gate and partially wraps around the second gate.

Example 17 provides the IC structure according to examples 15 or 16, where the third gate partially wraps around the first gate and partially wraps around the second gate.

Example 18 provides the IC structure according to example 14, where the insulator is a first insulator and is in contact with the portion of the first gate without being in contact with the portion of the second gate, and where the IC structure further includes a second insulator in contact with the portion of the second gate; and a fourth gate in contact with a portion of the second insulator, where the second insulator includes one of (1) the FE material, (2) the AFE material, or (3) the charge-trapping arrangement.

Example 19 provides an IC package that includes an IC die, including a transistor; and a further component, coupled to the IC die, where: a gate stack of the transistor includes a stack of a first insulator, a first conductive material, a second insulator, and a second conductive material, the first conductive material is between the first insulator and the second insulator, the second insulator is between the first conductive material and the second conductive material, and at least about 5% of the second insulator is in an orthorhombic phase or in a tetragonal phase.

Example 20 provides the IC package according to example 19, where the further component is one of a package substrate, an interposer, or a further IC die.

Example 21 provides the IC package according to examples 19 or 20, where the second insulator is a FE material or an AFE material.

Example 22 provides the IC package according to examples 19 or 20, where at least about 90% of the first insulator is amorphous or in a monoclinic phase.

Example 23 provides the IC package according to any one of examples 19-22, further including an insulator material around at least a portion of the IC die.

Example 24 provides the IC package according to any one of examples 19-23, further including interconnects between the further component and the IC die.

Example 25 provides the IC package according to example 24, where the interconnects are solder bumps.

Example 26 provides the IC package according to example 24, where the interconnects are hybrid bonding interconnects.

Example 27 provides the IC package according to any one of examples 24-26, further including first conductive contacts at a surface of the further component closest to the IC die; and second conductive contacts at a surface of the IC die closest to the further component, where the interconnects are between the first conductive contacts and the second conductive contacts.

Example 28 provides the IC package according to example 27, where at least one of the first conductive contacts or the second conductive contacts includes a conductive pad.

Example 29 provides the IC package according to example 27, where at least one of the first conductive contacts or the second conductive contacts includes a conductive socket.

Example 30 provides the IC package according to any one of examples 19-29, where: the further component is an interposer, the IC package further includes a package substrate coupled to the interposer, the IC die is coupled to a first face of the interposer, and the package substrate is coupled to a second face of the interposer opposite the first face of the interposer.

Example 31 provides the IC package according to example 30, further including interconnects between the interposer and the package substrate.

Example 32 provides the IC package according to example 31, further including an underfill material around the interconnects.

Example 33 provides an electronic device that includes a carrier substrate; and one or more of the transistors or IC structures according to any one of the preceding examples and/or the IC package according to any one of the preceding claims, coupled to the carrier substrate.

Example 34 provides the electronic device according to example 33, where the carrier substrate is a motherboard.

Example 35 provides the electronic device according to example 33, where the carrier substrate is a PCB.

Example 36 provides the electronic device according to any one of examples 33-35, where the electronic device is a wearable electronic device (e.g., a smart watch) or handheld electronic device (e.g., a mobile phone).

Example 37 provides the electronic device according to any one of examples 33-36, where the electronic device further includes one or more communication chips and an antenna.

Example 38 provides the electronic device according to any one of examples 33-37, where the electronic device is memory device.

Example 39 provides the electronic device according to any one of examples 33-37, where the electronic device is one of an RF transceiver, a switch, a power amplifier, a low-noise amplifier, a filter, a filter bank, a duplexer, an upconverter, or a downconverter of an RF communications device, e.g., of an RF transceiver.

Example 40 provides the electronic device according to any one of examples 33-37, where the electronic device is a computing device.

Example 41 provides the electronic device according to any one of examples 33-40, where the electronic device is included in a base station of a wireless communication system.

Example 42 provides the electronic device according to any one of examples 33-40, where the electronic device is included in a user equipment device (i.e., a mobile device) of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A transistor, comprising:
a channel material;
a first gate electrode material;
a first insulator, wherein the first insulator is between the channel material and the first gate electrode material;
a second insulator, wherein the first gate electrode material is between the first insulator and the second insulator; and
a second gate electrode material, wherein the second insulator is between the first gate electrode material and the second gate electrode material.

2. The transistor according to claim 1, wherein the second insulator is a ferroelectric (FE) material or an antiferroelectric (AFE) material.

3. The transistor according to any one of claims 1-2, wherein at most about 95% of the second insulator is amorphous or in a monoclinic phase.

4. The transistor according any one of claims 1-3, wherein the second insulator includes a first layer and a second layer, the first layer includes silicon and nitrogen, and the second layer includes silicon and oxygen.

5. The transistor according to any one of claims 1-4, wherein the second insulator is in contact with the first gate electrode material.

6. The transistor according to any one of claims 1-5, wherein the second gate electrode material is in contact with the second insulator.

7. The transistor according to any one of claims 1-6, wherein a thickness of the second insulator is between about 3 nanometers and 25 nanometers.

8. The transistor according to any one of claims 1-7, wherein the channel material is shaped as a nanoribbon, the first insulator wraps around the nanoribbon and the second insulator material does not wrap around the nanoribbon.

9. An integrated circuit (IC) structure, comprising:
a plurality of first nanoribbons stacked above one another;
a plurality of second nanoribbons stacked above one another;
a first gate at least partially wrapping around the plurality of first nanoribbons;
a second gate at least partially wrapping around the plurality of second nanoribbons;
an insulator in contact with at least one of a portion of the first gate and a portion of the second gate; and
a third gate in contact with a portion of the insulator,
wherein the insulator includes one of (1) a ferroelectric (FE) material, (2) an antiferroelectric (AFE) material, or (3) a charge-trapping arrangement.

10. The IC structure according to claim 9, wherein the insulator is in contact with both the portion of the first gate and the portion of the second gate.

11. The IC structure according to claim 10, wherein the insulator partially wraps around the first gate and partially wraps around the second gate.

12. The IC structure according to claims 10 or 11, wherein the third gate partially wraps around the first gate and partially wraps around the second gate.

13. The IC structure according to one of the claims 9-12, wherein the insulator is a first insulator and is in contact with the portion of the first gate without being in contact with the portion of the second gate, and wherein the IC structure further includes:
a second insulator in contact with the portion of the second gate; and
a fourth gate in contact with a portion of the second insulator,
wherein the second insulator includes one of (1) the ferroelectric (FE) material, (2) the antiferroelectric (AFE) material, or (3) the charge-trapping arrangement.

14. An integrated circuit (IC) package, comprising:
an IC die, comprising a transistor; and
a further component, coupled to the IC die,
wherein:
a gate stack of the transistor includes a stack of a first insulator, a first conductive material, a second insulator, and a second conductive material,
the first conductive material is between the first insulator and the second insulator,
the second insulator is between the first conductive material and the second conductive material, and
at least about 5% of the second insulator is in an orthorhombic phase or in a tetragonal phase.

15. The IC package according to claim 14, wherein at least about 90% of the first insulator is amorphous or in a monoclinic phase.
